(19) Europäisches Patentamt
European Patent Office
Office européen des brevets

(11) **EP 1 378 089 B1**

(12) **FASCICULE DE BREVET EUROPEEN**

(45) Date de publication et mention
de la délivrance du brevet:
**13.06.2012 Bulletin 2012/24**

(21) Numéro de dépôt: **02732814.5**

(22) Date de dépôt: **11.04.2002**

(51) Int Cl.:
*H04L 1/00* (2006.01)     *H04L 1/06* (2006.01)
*H03M 13/45* (2006.01)     *H03M 13/25* (2006.01)
*H03M 13/29* (2006.01)

(86) Numéro de dépôt international:
**PCT/FR2002/001276**

(87) Numéro de publication internationale:
**WO 2002/084931 (24.10.2002 Gazette 2002/43)**

(54) **Décodage et égalisation turbo conjointe pour transmission MIMO avec interférence intersymboles**

Gemeinsame Turbodecodierung und -entzerrung für MIMO Übertragung mit Intersymbolinterferenz

Joint turbo decoding and equalization for MIMO transmission with intersymbol interference

(84) Etats contractants désignés:
**AT BE CH CY DE DK ES FI FR GB GR IE IT LI LU MC NL PT SE TR**

(30) Priorité: **12.04.2001 FR 0105037**

(43) Date de publication de la demande:
**07.01.2004 Bulletin 2004/02**

(73) Titulaire: **FRANCE TELECOM**
**75015 Paris (FR)**

(72) Inventeurs:
• **BERTHET, Antoine**
**F-92290 Châtenay Malabry (FR)**
• **VISOZ, Rapha¬l**
**F-92130 Issy-les-Moulineaux (FR)**

(74) Mandataire: **Hassine, Albert**
**Cabinet Plasseraud**
**52 rue de la Victoire**
**75440 Paris Cedex 09 (FR)**

(56) Documents cités:
• **TONELLO A M: "Space-time bit-interleaved coded modulation over frequency selective fading channels with iterative decoding" PROCEEDINGS OF GLOBAL TELECOMMUNICATIONS CONFERENCE GLOBECOM'00, vol. 3, 27 novembre 2000 (2000-11-27) - 1 décembre 2000 (2000-12-01), pages 1616-1620, XP002180266 San Francisco, CA, USA**

• **BOUTROS J J ET AL: "Bit-interleaved coded modulations for multiple-input multiple-output channels" PROCEEDINGS OF INTERNATIONAL IEEE SYMPOSIUM ON SPREAD SPECTRUM TECHNIQUES AND APPLICATIONS (6TH ISSSTA), vol. 1, 6 - 8 septembre 2000, pages 123-126, XP002180267 Parsippany, NJ, USA cité dans la demande**

• **STEFANOV A ET AL: "TURBO CODED MODULATION FOR SYSTEMS WITH TRANSMIT AND RECEIVE ANTENNA DIVERSITY" 1999 IEEE GLOBAL TELECOMMUNICATIONS CONFERENCE. GLOBECOM'99. SEAMLESS INTERCONNECTION FOR UNIVERSAL SERVICES. RIO DE JANEIRO, BRAZIL, DEC. 5-9, 1999, IEEE GLOBAL TELECOMMUNICATIONS CONFERENCE, NEW YORK, NY: IEEE, US, vol. 5, 5 décembre 1999 (1999-12-05), pages 2336-2340, XP000958539 ISBN: 0-7803-5797-3 cité dans la demande**

• **BAUCH G ET AL-DAHIR N: "Iterative equalization and decoding with channel shortening filters for space-time coded modulation" VEHICULAR TECHNOLOGY CONFERENCE FALL 2000. IEEE VTS FALL VTC2000, vol. 4, 24 - 28 septembre 2000, pages 1575-1582, XP002180247 Boston, MA, USA**

• **SU H-J ET GERANIOTIS E: "Space-time turbo codes with full antenna diversity" IEEE TRANSACTIONS ON COMMUNICATIONS, vol. 49, no. 1, janvier 2001 (2001-01), pages 47-57, XP002180268 USA**

**EP 1 378 089 B1**

- **SIRIKIAT LEK ARIYAVISITAKUL: "Turbo Space-Time Processing to Improve Wireless Channel Capacity", IEEE TRANSACTIONS ON COMMUNICATIONS, IEEE SERVICE CENTER, PISCATAWAY, NJ. USA, vol. 48, no. 8, 1 August 2000 (2000-08-01) , pages 1347-1359, XP011010914, ISSN: 0090-6778, DOI: DOI: 10.1109/26.864172**

**Description**

L'invention concerne un procédé de codage/décodage d'un flux de données numériques codées avec un entrelacement sur bits en émission et en réception multiple en présence d'interférence intersymboles et un système correspondant.

De manière plus spécifique, le procédé de codage/décodage et le système, objets de l'invention, sont plus particulièrement adaptés à la mise en oeuvre de systèmes de transmission en radiofréquences à haut ou très haut débit utilisables dans le cadre de la téléphonie mobile ou, le cas échéant, dans le domaine de la liaison radiofréquences entre appareils électroniques, en environnement quelconque, particulièrement sévère.

Dans les domaines d'application précités, la transmission de données numériques à un haut degré de fiabilité et de sécurité se heurte à un obstacle majeur, celui de la transmission de ces données par l'intermédiaire d'un canal de transmission variable et dont les caractéristiques ne sont pas connues a priori. Les données numériques transmises sont subdivisées en symboles, constitués par des suites de bits de ces données, chaque symbole permettant la modulation d'une onde radioélectrique porteuse transmise sur le canal.

La très forte demande de processus de transmission fiable à haut débit en radiofréquence a provoqué le lancement et l'exécution de nombreux travaux de recherche relatifs à la définition et à la mise en oeuvre de systèmes de radiocommunication mobiles A.M.R.T. (Accès Multiple à Répartition dans le Temps) de future génération, encore désignés systèmes T.D.M.A. pour *Time Division Multiple Access* en langage anglo-saxon.

Les canaux de transmission en radiofréquences sont connus par le fait qu'ils sont à la fois sélectifs en fréquence et variables dans le temps. La variation temporelle est consécutive à la mobilité ou à la vitesse du ou des utilisateurs. Leur sélectivité en fréquence résulte des conditions de propagation des signaux radiofréquences par trajets multiples et de la superposition destructive des signaux reçus, issus des propagations sur ces trajets différents. Le phénomène de sélectivité en fréquence provoque un phénomène d'interférence intersymboles, préjudiciable à la qualité de la transmission et de la détection de ces symboles à leur réception. Le phénomène d'interférence intersymboles et la complexité des récepteurs sont sensiblement accrus avec le débit de transmission.

Ces caractéristiques spécifiques des canaux de transmission en radiofréquences précédemment citées ont toujours conduit à la mise en oeuvre de systèmes d'interfaçage radiofréquences adaptés particulièrement délicate, ce d'autant plus lorsqu'une transmission à haut débit et à haute efficacité spectrale est recherchée.

Toutefois la sélectivité en fréquence et la variation temporelle précitées des canaux de transmission en radiofréquences, considérées à priori comme des obstacles majeurs, ont cependant pu faire l'objet jusqu'à ce jour d'investigations, par intermédiaire du concept de diversité, ainsi qu'il sera explicité ci-après.

Parmi les travaux et développements précités, le processus de modulations codées avec entrelacements sur bits, encore désignées *Bit Interleaved Coded Modulations* ou *BICM* en langage anglo-saxon, sont connus depuis environ dix ans.

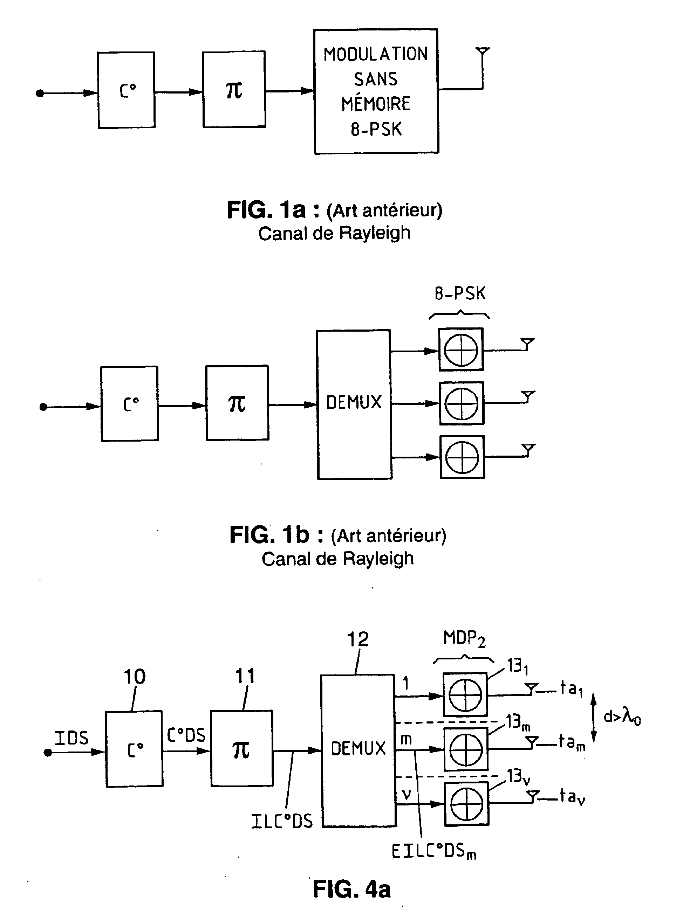

D'une manière générale, ainsi que décrit ci-après en référence à la figure 1a, ces processus consistent à appliquer à un flux numérique d'origine un code externe, C°, suivi d'un entrelacement, n, sur les bits d'un bloc de longueur en nombre de bits déterminée, puis d'une modulation de GRAY. Pour une description plus détaillée de ces processus, on pourra utilement se reporter à l'article intitulé "8-PSK Trellis Codes for a Rayleigh Channel", publié par Ephraim ZEHAVI, IEEE Transactions on Communications, vol.40, n°5, 1992.

Les processus de ce type ont récemment fait l'objet d'études théoriques ou pratiques nouvelles.
Parmi les études précitées, on peut citer celles publiées par G.CAIRE, G. TARICCO et E. BIGLIERI intitulée "Bit Interleaved Coded Modulation", IEEE Trans. Inform. Theory, vol.44, n°3, pp. 927-946, Mai 1998 et par X.LI et J.A. RITCEY intitulée "Trellis-Coded Modulation with Bit-Interleaving and Iterative Decoding", IEEE ISAC, vol.17, n°4, pp. 715-725, Avril 1992.

Plus récemment, les études précitées ont été généralisées à un système à antennes multiples en émission et en réception.
Un tel processus, plus élaboré, correspond au schéma illustratif tel que représenté en figure 1b dans lequel le démultiplexage sur un nombre donné de voies, après le processus d'entrelacement, permet de mettre en oeuvre le processus d'émission multiple, ainsi que représenté sur la figure précitée.
Un tel processus est essentiellement mis en oeuvre pour un canal de Rayleigh, c'est-à-dire pour un canal de transmission à effet de mémoire pratiquement absent, soit en l'absence de phénomène d'interférence intersymboles.
Un tel processus ne peut donc facilement être mis en oeuvre en environnement réel dans lequel le phénomène d'interférence intersymboles est toujours présent, en particulier dans le cadre des transmissions à haut ou très haut débit, les conditions de transmission à haut ou très haut débit ayant pour effet d'accroître fortement le phénomène d'interférence intersymboles précité, en raison de l'effet de mémoire précité.
Pour une description plus détaillée du processus précédemment mentionné, on pourra utilement se reporter à l'article intitulé "Bit-Interleaved Coded Modulations for Multiple-Input Multiple Output Channels" publié par JJ. BOUTROS, F. BOIXADERA, C. LAMY, IEEE 6th Int. Sum. on Spread Spectrum Tech & Appli. NSIT New Jersey, USA, Sept.6-6, 2000, et à l'article intitulé "Turbo Coded Modulation for Systems with Transmit and Receive Antenna Diversity" publié par Andrej STEFANOV, Tolga M. DUMAN, Telecommunications Research Center, Electrical Engineering Department, Arizona State University, Tempe, AZ 85287-7206, Global Telecommunications Conference - Globecom 99. La technique mise en oeuvre selon le processus précité présente ainsi l'inconvénient majeur de ne pas supporter la sélectivité fréquentielle des canaux de transmission élémentaires, d'antenne d'émission à antenne de réception, constituant le canal de transmission global. En d'autres termes, la technique précitée apparaît inadaptée à la mise en oeuvre d'une correction du phénomène d'interférence intersymboles.

Il a été proposé récemment un codage avantageux mettant en oeuvre des interfaces radiofréquences, permettant de garantir une haute efficacité spectrale, dans la publication : "Space-Time Bit-Interleaved Coded Modulation over Frenquency Selective Fading Channels with Iterative Decoding", par A.M.TONELLO, GLOBECOM 2000, Vol.3, pages 1616-1620, San Francisco, USA, novembre 2000. Cependant, les principes de codage/décodage énoncés dans cette publication, quoique prometteurs, prévoient, à la réception, des opérations de détection multicouches et de décodage d'interférences intersymboles, d'une part, et de décodage externe, d'autre part, de manière disjointe et itérative, en faisant usage d'algorithmes optimaux. Un système de décodage, basé sur un tel principe, est d'une grande complexité et difficile à mettre en oeuvre, en pratique.

Le document « Turbo Space-Time Processing to Improve Wireless Channel Capacity », Sirikiat Lek Aryavisitakul, XP011010914, pages 1347-1359, décrit un procédé d'égalisation et de suppression d'interférences de flux de données reçus sur une pluralité de M antennes réceptrices.

La présente invention vise un procédé et un système de décodage d'un flux de données numériques codées avec entrelacement sur bits en émission et en réception multiple en présence d'interférence intersymboles.

Le procédé et le système de décodage, au sens de la présente invention, ont pour objet de remédier aux inconvénients et pallier les insuffisances des processus et techniques de l'art antérieur.

En particulier, le procédé et le système de décodage, objets de la présente invention, sont plus particulièrement adaptés à la mise en oeuvre d'interfaces radiofréquences permettant de garantir une haute efficacité spectrale.

Un objet de la présente invention est de fournir un procédé et un système de décodage d'un flux de données numériques codées avec entrelacement sur bits en émission et en réception multiple en présence d'interférence intersymboles, à la fois simples dans leur mise en oeuvre et robustes.

Un autre objet de la présente invention est la mise en oeuvre d'un procédé et d'un système de décodage particulièrement adaptés à la définition et à la réalisation d'interfaces radiofréquences particulièrement robustes aux canaux de transmission très sélectifs en fréquence, ou de manière équivalente, permettant de combattre très efficacement le phénomène d'interférence intersymboles.

Un autre objet de la présente invention est enfin de fournir un procédé et un système de décodage de données numériques codées avec entrelacement sur bits en émission et en réception plus particulièrement adaptés à la mise en oeuvre d'interfaces radiofréquences permettant d'atteindre de très bonnes performances en termes de taux d'erreur bits et trames à rapport signal à bruit limité.

Au sens de la présente invention, on prévoit initialement un codage consistant à soumettre le flux de données numériques à un codage externe au moyen d'un code de rendement déterminé, pour engendrer un flux numérique codé, soumettre ce flux numérique codé à un entrelacement au niveau bit pour engendrer un flux numérique codé entrelacé, soumettre ce flux numérique codé entrelacé à un démultiplexage de couche sur un nombre $\nu$ de voies démultiplexées déterminé, pour engendrer un nombre correspondant de couches de flux numérique codé entrelacé, convertir chaque suite numérique de modulation constituée par $q_m$ bits successifs d'une même couche en un symbole $Q_m$-aire, $Q_m=2^{q_m}$, avec $m \in [1, \nu]$, selon un schéma de correspondance spécifique, transmettre chaque symbole $Q_m$-aire au moyen d'une antenne d'émission distincte, l'ensemble de ces antennes formant un réseau à diversité spatiale pour engendrer un ensemble de flux numériques élémentaires transmis. Ce processus opératoire permet, à la réception, d'effectuer un décodage de l'ensemble des flux numériques élémentaires transmis, à partir d'une information a priori sur les bits codés constitutifs du flux numérique codé.

Le procédé et le système de décodage d'un flux de données numériques codées avec entrelacement sur bits en émission et en réception multiple sur un canal de transmission générateur d'interférences intersymboles, conformément au procédé ou grâce au système de codage précité, objets de la présente invention, consiste à, respectivement permet de recevoir, sur une pluralité $\rho$ d'antennes de réception, ce flux de données numériques codées avec entrelacement sur bits en émission et en réception multiple constitué par cet ensemble de flux numériques élémentaires transmis sur ce canal de transmission, ces antennes de réception étant en nombre $\rho$ indépendant du nombre $\nu$ d'antennes d'émission et formant un réseau d'antennes de réception à diversité spatiale pour définir un ensemble de flux élémentaires de symboles de modulation reçus, soumettre cet ensemble de flux élémentaires de symboles de modulation reçus à un processus itératif d'égalisation du canal de transmission et de détection conjointe multicouche au moyen d'un flux d'information extrinsèque sur les bits codés par ce code externe et entrelacés, ce flux d'information extrinsèque constituant une information a priori, pour engendrer un premier flux d'information extrinsèque sur les bits codés par le code externe et entrelacés, soumettre le premier flux d'information extrinsèque à un désentrelacement, pour engendrer un deuxième flux d'information extrinsèque sur les bits codés en provenance du processus d'égalisation, soumettre ce deuxième flux d'information extrinsèque sur les bits codés à un décodage à partir du code externe, pour engendrer un troisième flux d'information extrinsèque sur les bits codés, issu du décodage à partir du code externe, soumettre ce troisième flux d'information extrinsèque à un entrelacement, pour engendrer le flux d'information extrinsèque sur les bits codés par le code externe et entrelacés constituant cette information a priori, réinjecter cette information a priori dans le processus itératif d'égalisation du canal de transmission et de détection conjointe multicouche.

Le procédé et le système de décodage d'un flux de données numériques codées avec entrelacement sur bits en émission et en réception multiple en présence d'interférence intersymboles, objets de la présente invention, trouvent application non seulement à la radiotéléphonie mobile, mais également à la mise en oeuvre d'interfaces radiofréquences entre appareils électroniques de tout type, en environnement domestique ou industriel.

Ils seront mieux compris à la lecture de la description ci-après et à l'observation des dessins dans lesquels, outre les figures 1a et 1b relatives à des processus de l'art antérieur :

- la figure 2 représente, à titre illustratif, un organigramme du procédé de codage d'un flux de données numériques codées avec entrelacement sur bits en émission et en réception multiple en présence d'interférence intersymboles, au sens de la présente invention ;
- la figure 3a représente, à titre illustratif, un organigramme du procédé de décodage, objet de la présente invention, d'un flux de données numériques codées en émission et en réception multiple, conformément au procédé de codage illustré en figure 2 ;
- la figure 3b représente, à titre illustratif, un organigramme d'un détail de mise en oeuvre d'un processus itératif d'égalisation et détection conjointe multicouche dans le cadre du procédé de décodage selon l'invention tel que représenté en figure 3b ;
- la figure 3c représente, à titre illustratif, un organigramme d'un détail de mise en oeuvre d'un processus de décodage à entrée/sortie souple, à partir d'un code externe, permettant d'obtenir un flux d'information extrinsèque sur les bits codés, issu du décodage à partir de ce code externe ;
- la figure 4a représente, à titre illustratif, un schéma fonctionnel d'un système de codage d'un flux de données numériques codées avec entrelacement sur bits en émission et en réception multiple en présence d'interférence intersymboles, au sens de la présente invention ;
- la figure 4b représente, à titre illustratif, un schéma fonctionnel d'un système de décodage, objet de la présente invention, d'un flux de données numériques codées avec entrelacement sur bits en émission et en réception multiple en présence d'interférence intersymboles, conformément au procédé de codage illustré en figure 2 et au moyen du système de codage représenté en figure 3a ;
- la figure 5a représente, à titre illustratif, un diagramme de la valeur du taux d'erreur bit en fonction du rapport signal à bruit lors de la mise en oeuvre d'un processus de codage de l'art antérieur illustré en figure 1a, une égalisation BCJR à partir d'un treillis à 64 états étant appliquée pour assurer le décodage ;
- la figure 5b représente, à titre illustratif, un diagramme de la valeur du taux d'erreur bit en fonction du rapport signal à bruit lors de la mise en oeuvre du procédé de codage, au sens de la présente invention, tel que représenté en figure 2, pour une émission multiple à trois antennes d'émission en modulation de phase à deux états $MDP_2$, le décodage étant réalisé conformément au procédé de décodage objet de la présente invention par égalisation et détection conjointe itérative de type BCJR ;
- la figure 5c représente, à titre illustratif, un diagramme de la valeur du taux d'erreur bit en fonction du rapport signal à bruit lors de la mise en oeuvre du procédé de codage et du procédé de décodage objet de la présente invention, pour un nombre d'antennes d'émission égal à 4 ;

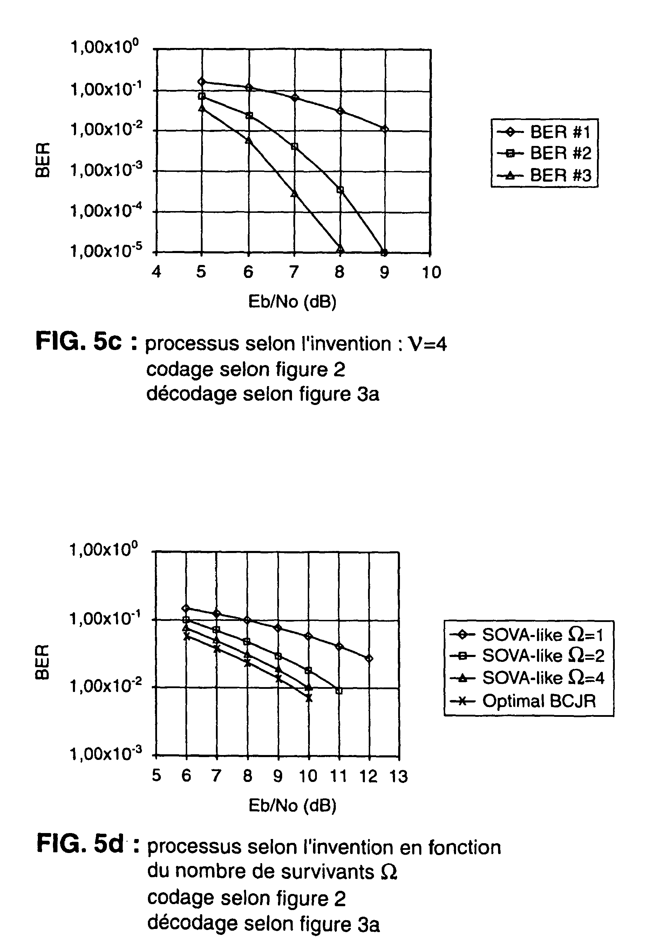

- la figure 5d représente, à titre illustratif, un diagramme comparatif de la valeur du taux d'erreur bit en fonction du rapport signal à bruit lors de la mise en oeuvre du procédé de codage et du procédé de décodage objet de la présente invention, le processus d'égalisation et de détection conjointe multicouche étant un processus GPSP consistant à conserver $\Omega$ survivants par noeud du treillis réduit global, le calcul des sorties pondérées consistant en un processus de type SOVA généralisé, le diagramme comparatif étant établi pour différentes valeurs du nombre $\Omega$ de survivants vis-à-vis d'un processus optimal BCJR.

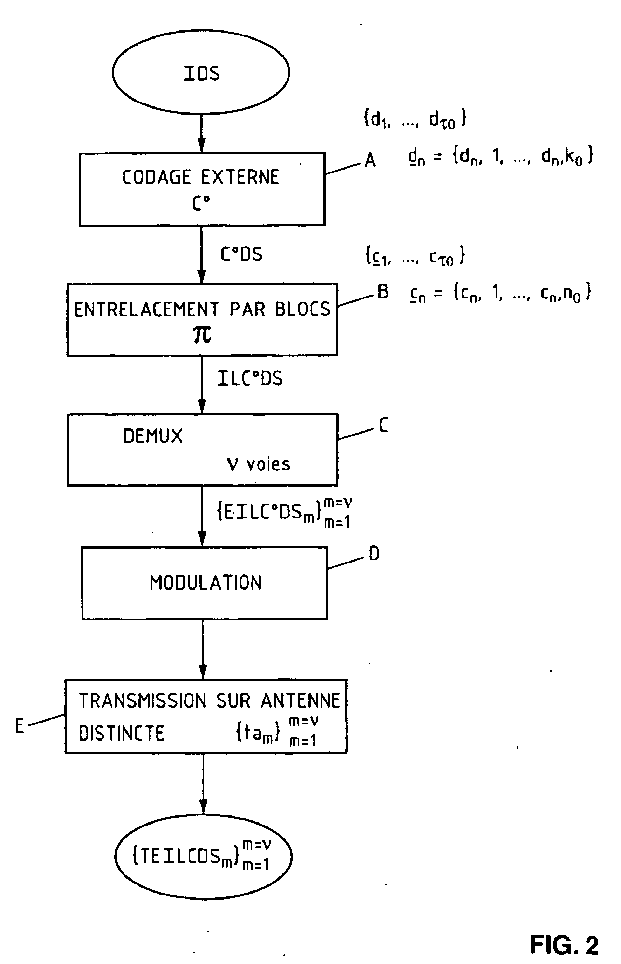

Une description plus détaillée du procédé de codage de flux de données numériques codées avec un entrelacement sur bits en émission et en réception multiple, au sens de la présente invention, sera maintenant donnée en liaison avec la figure 2.

En référence à la figure précitée, on indique que le procédé de codage s'applique à un flux de données initial, noté IDS, constituant une séquence de données externes notées $\{\underline{d}_1, ...\underline{d}_{\tau 0}\}$, cette séquence de données externes correspondant à des symboles constitués par des bits successifs, notés $\underline{d}_n = \{d_{n,1}, ...d_{n,k0}\}$.

On rappelle que pour la transmission de données numériques codées, la subdivision de ces données numériques en symboles constitués par un certain nombre déterminé de bits successifs permet d'assurer une modulation de canal en vue de la transmission de ces symboles et, en définitive, de la séquence de données constituée par ces derniers indépendamment de toute valeur significative de la séquence constituée par ces bits successifs.

Ainsi qu'on l'observera sur la figure 2, le flux initial de données numériques IDS est soumis, en une étape A, à un codage externe au moyen d'un code de rendement déterminé pour engendrer un flux numérique codé. Sur la figure 1a précitée, le code permettant d'effectuer le codage externe est noté C˚.

D'une manière plus spécifique, on indique que le code externe peut avantageusement être constitué par un code en treillis ou, de manière équivalente, par une combinaison de codes en treillis. Le flux numérique codé obtenu suite à l'étape A est noté C⫫DS sur la figure 2. Il consiste en une séquence codée externe, notée $\{\underline{c}_1, ..., \underline{c}_{\tau 0}\}$, cette séquence codée externe consistant en des symboles de bits codés notés $\underline{c}_n = \{c_{n,1}, ..., c_{n,n0}\}$ où $c_{n,1}$ à $c_{n,n0}$ dénotent les bits successifs constitutifs du symbole codé $\underline{c}_n$.

Le flux numérique codé C⫫DS est ensuite soumis à une étape B, après une subdivision en blocs successifs par exemple, à un processus d'entrelacement par blocs pour engendrer un flux numérique codé entrelacé, noté ILC⫫DS, présentant ainsi, du fait, d'une part, du codage externe à l'étape A et de l'entrelacement, d'autre part, une diversité temporelle.

D'une manière générale, on indique que le processus d'entrelacement par blocs à l'étape B peut être mis en oeuvre au moyen d'un système entrelaceur aléatoire noté n.

L'étape B est elle-même suivie d'une étape C consistant à soumettre le flux numérique codé et entrelacé ILC⫫DS à un démultiplexage, le flux numérique codé et entrelacé ILC⫫DS étant, par cette opération, subdivisé en un nombre donné ν de flux numériques codés entrelacés élémentaires, l'ensemble de ces flux numériques codés entrelacés élémentaires étant noté sur la figure 2 :

$$\left\{ \text{EILC}^0\text{DS}_m \right\}_{m=1}^{m=\nu}$$

On conçoit que chaque flux numérique entrelacé élémentaire constitue en fait une couche de rang m, laquelle, outre la qualité de diversité temporelle introduite du fait du codage externe et de l'entrelacement, permet, ainsi qu'il sera décrit ultérieurement dans la description, d'introduire un codage spatial spécifique.

L'étape C précitée est alors suivie d'une étape D consistant à soumettre chaque flux numérique codé entrelacé élémentaire, c'est-à-dire chaque signal au niveau de chaque couche de rang $m \in [1,\nu]$ à un processus de modulation permettant de convertir chaque suite numérique de modulation, constituée par $q_m$ bits successifs d'une même couche, en un symbole $Q_m$-aire, $Q_m = 2^{qm}$ $m \in [1,\nu]$ selon un schéma de mise en correspondance spécifique.

En pratique, les couches de flux numérique codé entrelacé sont constituées en trames, à raison d'une trame par couche de rang m. En outre, chaque couche de rang m est elle-même subdivisée en N salves $\left\{ \underline{u}_1^m, \cdots \underline{u}_\tau^m \right\}$ de $\tau$ bits constitués en symboles $\underline{u}_n^m = \left\{ u_{n,1}^m, ..., u_{n,qm}^m \right\}$, ces $\tau$ bits comportant les bits de queue constitutifs de bits d'apprentissage, formés par exemple par des séquences CAZAC, connues en tant que telles. Chaque salve est soumise à une modulation par un modulateur $Q_m$-aire, lequel permet d'associer à tout symbole d'entrée $\underline{u}_n^m$ un symbole complexe de la forme

$$z_n^m = \varphi(\underline{u}_n^m) \ .$$

On indique que la fonction $\varphi$ désigne une loi de mise en correspondance ("mapping") quelconque. A titre d'exemple non limitatif, on indique que la loi de mise en correspondance selon un code de Gray s'est révélée donner de bons résultats. Ainsi, à la fin de l'étape D, on dispose sur chaque voie de modulation d'un symbole $Q_m$-aire noté $EILCDS_m$, où m désigne le rang de la voie de modulation.

L'étape D est elle-même suivie d'une étape E consistant à transmettre chaque symbole $Q_m$-aire $EILCDS_m$ précédemment mentionné sur un canal de transmission au moyen d'une antenne d'émission distincte.

L'ensemble des antennes d'émission distinctes, noté $\left\{ ta_m \right\}_{m=1}^{m=\nu}$, forme un réseau à diversité spatiale et permet en conséquence d'engendrer, à partir de chaque symbole $Q_m$-aire $EILCDS_m$, un ensemble de flux numériques élémentaires transmis présentant une diversité spatiale et temporelle, en raison, d'une part, du codage externe introduit compte tenu de l'entrelacement par blocs, et de la répartition de l'émission sur l'ensemble des antennes d'émission distinctes, d'autre part.

En ce qui concerne ce dernier, on indique que cet ensemble d'antennes d'émission forme un réseau à diversité spatiale, chaque antenne d'émission distincte constitutive de ce réseau étant distante d'une antenne d'émission distincte voisine d'une distance supérieure à $\lambda_0$, où $\lambda_0$ désigne la longueur d'onde de l'onde porteuse permettant d'assurer la transmission par modulation de chacun des symboles $Q_m$-aire obtenus à l'issue de l'étape D.

Le procédé de codage permet ainsi, à la réception, d'effectuer un décodage des symboles $Q_m$-aire constituant

l'ensemble de flux numériques élémentaires transmis $\{\mathrm{TEILCDS}\}_{m=1}^{m=\nu}$ à partir d'informations a priori représentatives de la diversité spatiale et temporelle introduite au codage.

De manière plus spécifique, on rappelle que les symboles d'apprentissage précités, connus en tant que tels, permettent, après transmission, d'effectuer une évaluation préalable de la réponse impulsionnelle du canal de transmission, le canal de transmission consistant en une pluralité de trajets de propagation entre l'émetteur et le récepteur, chaque trajet constituant un canal de transmission élémentaire.

Dans ces conditions, du fait de la propagation multi-trajets et du caractère variable du canal de transmission en raison de la mobilité entre l'émetteur et le récepteur, un canal radiofréquences sélectif en fréquence et variable dans le temps peut être modélisé par la réponse impulsionnelle en temps discret du canal équivalent, incluant bien entendu les filtres d'émission et de réception de mise en forme utilisés habituellement, chaque canal de transmission élémentaire correspondant étant noté pour cette raison :

$$\underline{h}^{m,r} = \left\{ h_0^{m,r}, \dots, h_{\chi_c - 1}^{m,r} \right\}$$

pour chaque trajet reliant une antenne d'émission de chaque couche m à une antenne de réception de rang r donné. D'une manière générale, $r \in [1,\rho]$ avec $\rho \neq \nu$. Le nombre d'antennes de réception peut être inférieur à $\nu$.

Dans la relation précédente, $\chi_c$ désigne la longueur de contrainte en nombre de symboles transmis, longueur de contrainte représentative de la mémoire du canal.

Tous les canaux élémentaires sont considérés présenter la même longueur de contrainte $\chi_c$. Une telle supposition est admissible car le nombre de composants de trajets multiples individuels est essentiellement déterminé par les structures larges et les objets réfléchissants.

Si, conformément au procédé au sens de la présente invention, on prend en considération la transmission salve par salve, alors, les canaux de transmission élémentaires et le canal de transmission résultant sont statiques pendant la durée de transmission d'une salve et changent de manière indépendante d'une salve à l'autre. Dans ces conditions, la valeur $\tau$ peut être considérée, en première approximation, comme une mesure du temps de cohérence du canal précité. Ces conditions permettent d'établir une modélisation acceptable pour des canaux quasi statiques multi-trajets à évanouissement de fréquence lentement variables et à saut de fréquence.

Les coefficients de chaque canal élémentaire, notés $\left\{ h_k^{m,r} \right\}_k$, peuvent, dans ce cas, être considérés comme des variables aléatoires complexes gaussiennes indépendantes, de même énergie moyenne nulle, vérifiant la relation (1) :

$$\sum_{i=0}^{\chi_c - 1} \left\| h_i^{m,r} \right\|^2 = 1 \qquad\qquad (1)$$

A chaque temps d'échantillonnage discret n, chaque antenne de réception de rang r observe, dans ces conditions, un ensemble de symboles transmis correspondant au flux numérique élémentaire transmis

$\{\mathrm{TEILCDS}_m\}_{m=1}^{m=\nu}$ et vérifiant la relation (2) :

$$y_n^r = \sum_{m=1}^{\nu} \sum_{i=0}^{\chi_c - 1} h_i^m \, z_{n-i}^{m,r} + \varsigma_n^r \qquad\qquad (2)$$

Dans cette relation $\varsigma_n^r$ représente un échantillon de bruit complexe de valeur moyenne nulle et de variance $2\sigma^2$. $\varsigma_n^r$ est une variable Gaussienne symétrique complexe, c'est-à-dire une variable dont la partie réelle et la partie imaginaire sont décorrélées et de même énergie $\sigma^2$.

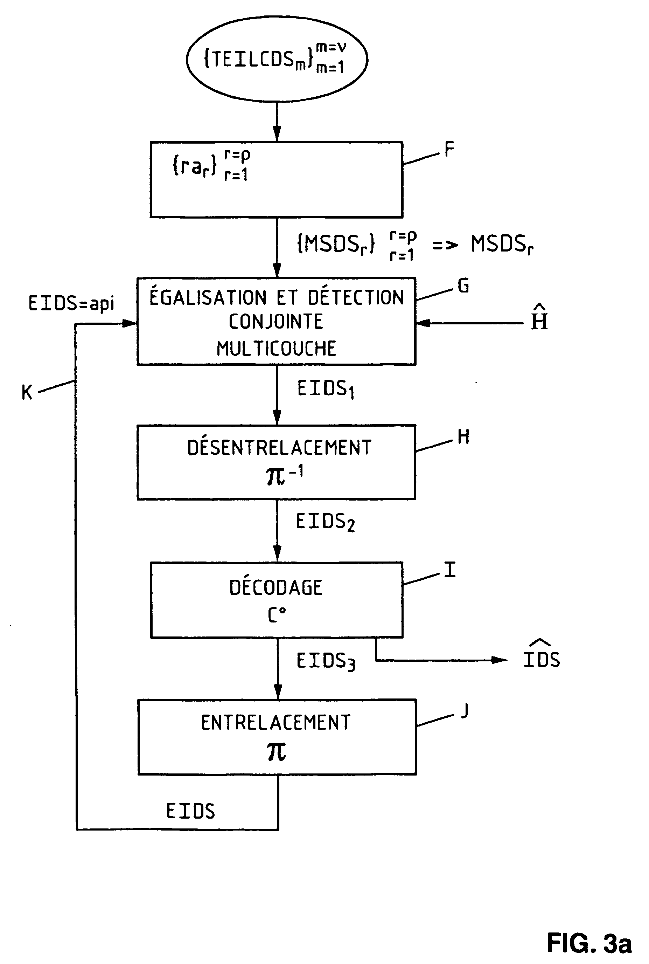

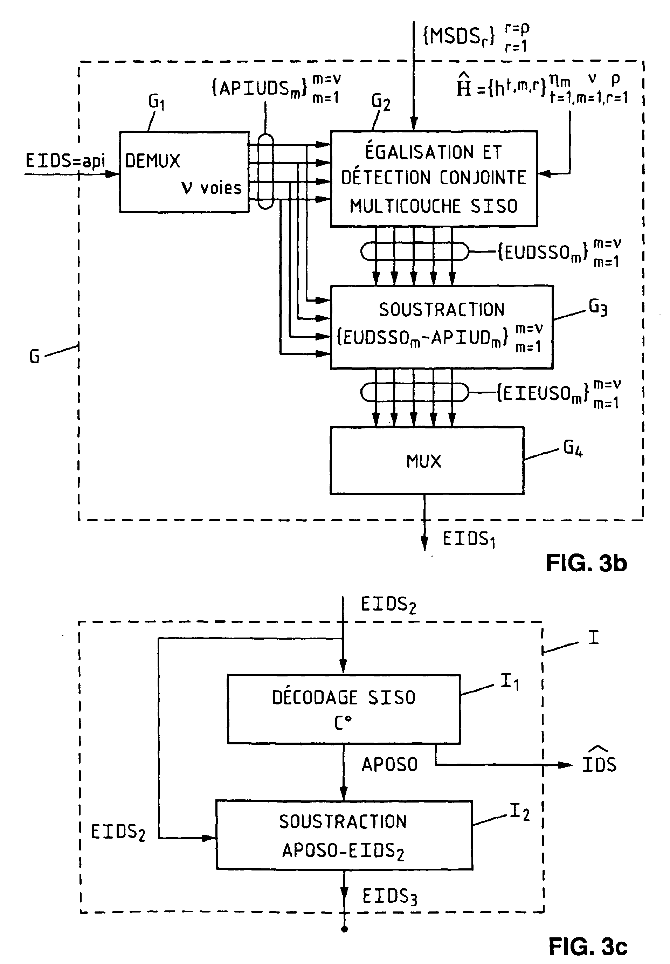

Un procédé de décodage d'un flux de données numériques codées avec un entrelacement sur bits en émission et en réception multiple, le codage de ce flux numérique ayant été effectué conformément au procédé tel que décrit en relation avec la figures 2 précitée, sera maintenant décrit en liaison avec les figures 3a, 3b et 3c.

En raison du codage de ces données numériques conformément au procédé précédemment décrit, on indique que le procédé de décodage, objet de l'invention, consiste, en une étape F, à recevoir le flux de données numériques codées constitué par l'ensemble de flux numériques élémentaires transmis sur un canal de transmission, cet ensemble de flux numériques élémentaires transmis étant noté $\{TEILCDS_m\}_{m=1}^{m=\nu}$, cette réception étant effectuée sur une pluralité $\rho$ d'antennes de réception. Sur la figure 3a, l'ensemble des antennes de réception est noté $\{ra_r\}_{r=1}^{r=\rho}$

Ces antennes de réception, en nombre indépendant du nombre d'antennes d'émission, peuvent être en nombre inférieur ou égal au nombre $\nu$ d'antennes d'émission et forment, conformément à un aspect avantageux du procédé de décodage, objet de la présente invention, un réseau d'antennes de réception à diversité spatiale, pour définir un ensemble de flux élémentaires de symboles de modulation reçus, cet ensemble de flux élémentaires de symboles de modulation reçus étant noté, à l'issue de l'étape F de la figure 3a, $\{MSDS_r\}_{r=1}^{r=\rho}$. On comprend en particulier que chaque symbole de modulation reçu est un symbole de la forme $y_n^r$ vérifiant la relation (2) précédemment mentionnée dans la description.

L'étape F est alors suivie d'une étape G consistant à soumettre l'ensemble des flux élémentaires de symboles de modulation reçus $\{MSDS_r\}_{r=1}^{r=\rho}$ à un processus itératif d'égalisation du canal de transmission et de détection conjointe multicouche au moyen d'un flux d'information extrinsèque sur les bits codés par le code externe et entrelacés, ce flux d'information extrinsèque étant issu d'un décodage à partir du code externe. Sur la figure 3a, le flux d'information extrinsèque sur les bits codés par le code externe et entrelacés est noté EIDS = api. En effet, ce flux d'information constitue une information a priori sur les bits codés et le processus d'égalisation et de détection conjointe multicouche, mis en oeuvre à l'étape G au moyen du flux d'information extrinsèque sur les bits codés EIDS = api, permet d'engendrer un premier flux d'information extrinsèque sur les bits codés par le code externe et entrelacés, ce premier flux d'information extrinsèque étant noté EIDS$_1$ sur la figure 3a.

L'étape G précitée est suivie d'une étape H consistant à soumettre le premier flux d'information extrinsèque EIDS$_1$ à un désentrelacement, noté $\pi^{-1}$, pour engendrer un deuxième flux d'information extrinsèque sur les bits codés en provenance du processus d'égalisation et de détection conjointe multicouche, ce deuxième flux d'information extrinsèque étant noté EIDS$_2$ sur la figure 3a. L'opération de désentrelacement est l'opération inverse de l'opération d'entrelacement réalisée lors de la mise en oeuvre du procédé de codage, ce processus de désentrelacement étant noté, pour cette raison, $\pi^{-1}$ sur la figure 3a.

Le deuxième flux d'information extrinsèque sur les bits codés EIDS$_2$ est alors soumis, à l'étape I, à un décodage à partir du code externe C° pour engendrer un troisième flux d'information extrinsèque sur les bits codés, noté EIDS$_3$, issu du décodage à partir du code externe C°. On note que, lors de cette opération I, le décodage fournit en outre une estimation de la valeur du signal numérique initial, noté pour cette raison ÎDS.

Suite à l'étape I, le troisième flux d'information extrinsèque est soumis à une opération d'entrelacement à l'étape J pour engendrer le flux d'information extrinsèque sur les bits codés par le premier code externe et entrelacés EIDS constituant l'information a priori sur les bits codés, notée api. Cette information a priori est alors réinjectée à l'étape K, symbolisée par la boucle de retour, dans le processus itératif d'égalisation du canal de transmission et de détection conjointe multicouche, c'est-à-dire à l'étape G de la figure 3a.

En référence à la figure 3a, on comprend en particulier que le procédé de décodage, objet de la présente invention, consiste essentiellement à effectuer une égalisation et une détection conjointe multicouche des données codées, cette égalisation et cette détection conjointe étant associées de manière itérative au décodage externe au moyen du code C˚ pour bénéficier de l'information a priori sur les bits codés api issue de la mise en oeuvre successive des étapes G, H, I et J. On comprend en particulier que le flux d'information extrinsèque sur les bits codés par le premier code externe et entrelacés, le flux noté EIDS sur la figure 3a, et constituant l'information a priori sur les bits codés api, est une information relative à chaque bit constitutif des symboles $z_n^m$ constituant le signal reçu à l'issue de l'étape F. Ainsi, cette information a priori constitue une information effective quant à la valeur des bits constitutifs des symboles précités et, en définitive, de la diversité spatiale et temporelle introduite par le processus de codage et d'émission décrit ci-avant.

Une description plus détaillée d'un mode particulier de mise en oeuvre du procédé de décodage objet de la présente invention sera maintenant donnée en liaison avec les figures 3b et 3c.

Dans le mode de réalisation spécifique précité, on indique que ce dernier correspond à la mise en oeuvre d'un processus d'égalisation et de détection conjointe à entrée et sortie pondérée, dit de type SISO (*soft input soft output*, en langage anglo-saxon).

Dans ces conditions, l'information a priori réinjectée dans le processus d'égalisation et de détection conjointe de type SISO est constituée, de manière avantageuse, par une valeur logarithmique du rapport de probabilité a priori de la valeur des bits codés, cette valeur logarithmique constituant l'information extrinsèque sur les bits codés par le code externe et entrelacés.

Ainsi que représenté en figure 3b, le processus G d'égalisation et de détection conjointe multicouche consiste à démultiplexer, en une étape $G_1$, le flux d'information extrinsèque sur les bits codés par le premier code externe et entrelacés EIDS, constituant l'information a priori api, en un ensemble de flux d'information a priori sur les bits des couches de flux numérique codé et entrelacé, cet ensemble de flux d'information a priori sur les bits des couches de flux numérique codé et entrelacé étant noté $\{APIUDS_m\}_{m=1}^{m=\nu}$ sur la figure 3b.

L'étape $G_1$ est alors suivie d'une étape $G_2$ consistant à effectuer une égalisation et une détection conjointe à entrée/sortie souple, c'est-à-dire de type SISO, appliqués à un treillis réduit en nombre d'états. Ce treillis est défini comme le treillis des canaux à mémoire élémentaires constitutifs du canal de transmission, eux-mêmes réduits en nombre d'état, pour engendrer un ensemble de flux de sorties pondérées sur les bits de couches de flux numérique codé entrelacé. Ce flux de sorties pondérées sur les bits de couches de flux numérique codé entrelacés est noté $\{EUDSSO_m\}_{m=1}^{m=\nu}$.

L'étape $G_2$ est suivie d'une étape $G_3$ consistant à extraire de chaque flux de sorties pondérées sur les bits des couches de flux numérique codé entrelacés $\{EUDSSO_m\}_{m=1}^{m=\nu}$ l'information a priori sur les bits des couches de flux numérique codé entrelacés $\{APIDUS_m\}_{m=1}^{m=\nu}$ correspondantes, pour engendrer un flux d'information extrinsèque sur les bits des couches de flux numérique codé entrelacés, noté $\{EIEUSO_m\}_{m=1}^{m=\nu}$.

Lorsque le processus d'égalisation et de détection conjointe mis en oeuvre à l'étape $G_2$ est un processus d'égalisation et de détection de type SISO et que les entrées et sorties constituées par l'information a priori sur les bits des couches de flux numérique codé entrelacés $\{APIDUS_m\}_{m=1}^{m=\nu}$, respectivement par les flux de sorties pondérées sur les bits des couches de flux numérique codé entrelacés $\{EUDSSO_m\}_{m=1}^{m=\nu}$ sont des valeurs logarithmiques de probabilité, le processus d'extraction peut être mis en oeuvre, en raison de la nature logarithmique de ces informations d'entrée/sortie, par une soustraction, tel que représenté à l'étape $G_3$ de la figure 2b.

Cette soustraction est notée :

$$\{EUDSSO_m - APIUD_m\}_{m=1}^{m=\nu}.$$

On constate ainsi que, d'une part, le processus d'égalisation et de détection conjointe multicouche est effectué pour chaque couche de rang m et que, d'autre part, le processus d'extraction, et en particulier de soustraction dans le cas de la mise en oeuvre d'une égalisation et d'un décodage conjoint de type SISO, est également effectué pour chaque couche de rang m.

Suite à l'étape $G_3$, les flux d'information extrinsèque sur les bits des couches de flux numérique codé entrelacés $\{EIEUSO_m\}_{m=1}^{m=\nu}$ sont soumis à une opération de multiplexage $G_4$, pour engendrer le premier flux d'information extrinsèque sur les bits codés par le premier code externe et entrelacés, c'est-à-dire le flux $EIDS_1$.

De la même manière, ainsi que représenté en figure 3c, et lorsque le processus d'égalisation et de détection conjointe mis en oeuvre à l'étape $G_2$ de la figure 3b est de type SISO, l'étape de décodage au moyen du code externe à l'étape I de la figure 3a peut consister de manière avantageuse à soumettre, en une étape $I_1$, le deuxième flux d'information extrinsèque sur les bits codés en provenance du processus d'égalisation et de détection conjointe, flux d'information extrinsèque noté $EIDS_2$, à un décodage à entrée/sortie pondérée de type SISO au moyen du code externe $C°$ pour engendrer un flux de sortie pondérée, noté APOSO, représentatif d'une information a posteriori sur les bits codés. L'étape $I_1$ est suivie d'une étape $I_2$ consistant à extraire le deuxième flux d'information extrinsèque $EIDS_2$ du deuxième flux de sortie pondérée APOSO représentatif de l'information a posteriori sur les bits codés, pour engendrer le troisième flux d'information extrinsèque sur les bits codés $EIDS_3$. Dans le cas de la mise en oeuvre de l'étape $I_1$ sous forme d'un décodage SISO à partir du code externe $C°$, l'étape d'extraction à l'étape $I_2$ est également une étape de soustraction en raison du caractère logarithmique des valeurs numériques constitutives des flux $EIDS_2$ et APOSO.

Un justificatif théorique du mode opératoire du procédé de décodage, objet de la présente invention, tel que décrit en liaison avec les figures 3a, 3b et 3c, sera maintenant donné ci-après.

D'une manière générale, on indique que le processus d'égalisation et de décodage conjoint mis en oeuvre à l'étape G, et de manière plus spécifique à l'étape $G_2$ de la figure 2b, est mis en oeuvre sur l'ensemble des couches de rang m sur chacune des $\nu$ salves concomitantes, successivement, pour calculer le premier flux d'information extrinsèque sur les bits codés par le code externe et entrelacés, c'est-à-dire le flux $EIDS_1$, à partir du flux d'information extrinsèque sur les bits codés par le code externe et entrelacés issu d'un décodage à partir du code externe $C°$, le flux d'information extrinsèque précité EIDS, constituant l'information a priori sur les bits codés api.

On indique de manière classique que ce calcul est effectué à partir d'une estimation $\hat{H}$ des coefficients du canal de transmission, cette estimation étant obtenue à partir des symboles d'apprentissage reçus dans les flux élémentaires de symboles de modulation reçus $TEILCDS_m$.

Dans le cas, ainsi que représenté en figure 2b, où le processus d'égalisation et de décodage conjoint réalisé à l'étape $G_2$ est de type SISO, les entrées et sorties de ce décodage correspondant à des séquences de valeur logarithmique du rapport des probabilités extrinsèques sur chacun des bits de chaque symbole de modulation observé à partir de l'ensemble des N séquences de symboles observées par l'ensemble des antennes de réception, ces séquences observées étant notées $\left\{ y_1^r, \ldots, y_\tau^r \right\}_{r=1}^{r=\rho}$ et de longueur $\tau$ en nombre de symboles observés reçus, l'estimée $\hat{H}$ du canal de transmission s'exprime sous la forme d'un ensemble d'estimées des coefficients de chaque canal élémentaire d'une antenne de transmission à toutes les antennes de réception sous la forme $\hat{H} = \left\{ h^{m,r} \right\}_{m=1, r=1}^{\nu \quad \rho}$.

A la première itération du processus itératif d'égalisation et de détection conjointe, le calcul est effectué en l'absence de toute information préalable, les valeurs estimées des coefficients des canaux élémentaires étant simplement calculées à partir des séquences d'apprentissage et des séquences correspondantes obtenues sur les symboles de modulation observés. Les séquences de flux de sorties pondérées sur les bits des couches de flux numérique codé entrelacés $EUDSSO_m$ obtenues à l'issue de l'étape $G_2$ sont classées par trames, soumises à l'étape $G_3$ d'extraction et en particulier de soustraction à partir de l'information a priori api obtenue pour chacune des couches à partir de l'opération de démultiplexage $G_1$. Les flux d'information extrinsèque sur les bits des trames utilisateur obtenus à l'issue de l'étape $G_3$ et notés $\{EIEUSO_m\}_{m=1}^{m=\nu}$ sont ensuite soumis à l'opération de multiplexage de l'étape $G_4$, pour engendrer le premier flux d'information extrinsèque sur les bits codés par le premier code externe et entrelacés $EIDS_1$ précédemment cité.

L'opération de désentrelacement réalisée à l'étape H de la figure 3a sur le premier flux d'information extrinsèque sur les bits codés par le premier code externe et entrelacés permet alors d'engendrer le deuxième flux d'information extrinsèque sur les bits codés en provenance du processus d'égalisation et de décodage conjoint $EIDS_2$, lequel constitue une nouvelle séquence de valeurs logarithmiques de rapport de probabilité intrinsèque sur les bits codés, pour l'étape de décodage externe I à partir du code externe $C°$.

L'étape I précitée de décodage à partir du code externe $C°$ est alors effectuée, ainsi que représenté en figure 3c, par la succession des étapes $I_1$ et $I_2$ au moyen d'un décodage de type SISO et en particulier d'un algorithme BCJR dans le domaine logarithmique, l'étape de décodage $I_1$ permettant, dans ces conditions, d'évaluer la séquence des valeurs logarithmiques des rapports de probabilité extrinsèque sur chacun des bits de chacun des symboles codés par l'intermédiaire du code externe C°. Cette séquence est obtenue suite à l'extraction par soustraction à l'étape $I_2$ du deuxième flux d'information extrinsèque sur les bits codés $EIDS_2$, du flux de sortie pondérée représentatif de l'information a posteriori sur les bits codés APOSO précitées. Le troisième flux d'information extrinsèque sur les bits codés $EIDS_3$ représentatif de la valeur logarithmique des rapports de probabilité extrinsèque sur chacun des symboles codés par le premier code externe C° est ensuite soumis à l'étape J à un entrelacement pour engendrer l'information a priori EIDS = api. Cette information a priori api est alors réinjectée au niveau du processus d'égalisation et décodage SISO $G_2$ de la figure 3b, par l'intermédiaire d'un démultiplexage $G_1$ sur l'ensemble des ν voies ou couches. L'ensemble des informations correspondantes pour chaque couche et suite à segmentation par salves, pour constituer l'ensemble de flux d'information a priori sur les bits de couches divisées en salves ou paquets, est ainsi réintroduit au niveau du processus d'égalisation et de détection conjointe $G_2$. Le processus d'égalisation et de détection conjointe $G_2$ précité effectue alors l'égalisation et la détection sur n trames de ν séquences de valeur logarithmique du rapport de probabilité a priori sur les bits des symboles de modulation observés $\{MSDS_r\}_{r=1}^{r=\rho}$ .

Le procédé tel que décrit en figure 3a et en particulier en figures 3b et 3c, permet d'imbriquer un processus additionnel de réestimation de chaque canal élémentaire distinct générateur d'interférences intersymboles dans le processus itératif classique de turbo-détection.

Une description plus détaillée d'un système de codage d'un flux de données numériques codées par combinaisons spatio-temporelles, en émission et en réception multiple, sera maintenant donnée en liaison avec la figure 4a.

Ainsi que représenté sur la figure 4a, on indique que le système de codage comporte avantageusement un module 10 de codage externe d'un flux initial de données numériques IDS à partir d'un code C° de rendement déterminé, pour engendrer le flux numérique codé C⊔DS précédemment cité. Le module 10 de codage externe est suivi d'un module 11 d'entrelacement par blocs permettant, à partir du flux numérique codé C⊔DS, d'engendrer un flux numérique codé entrelacé présentant, du fait, d'une part, du codage externe préalablement introduit et de l'entrelacement réalisé, d'autre part, une diversité temporelle spécifique. Le flux numérique codé entrelacé est noté ILC⊔DS.

Ce module d'entrelacement 11 est lui-même suivi d'un module démultiplexeur 12 recevant le flux numérique entrelacé ILC⊔DS, le module démultiplexeur 12 permettant d'engendrer un nombre ν de flux numériques codés entrelacés élémentaires, ces flux numériques codés entrelacés élémentaires étant subdivisés en trames, elles-mêmes subdivisées en salves, ainsi que décrit précédemment dans la description.

Sur la figure 4a chaque flux numérique codé entrelacé élémentaire ou chaque trame constituant une couche de rang m est noté $EILC⊔DS_m$.

Le système de codage comporte en outre, ainsi que représenté en figure 3a, une pluralité de circuits modulateurs $Q_m$-aire, notés $13_1$ à $13_\nu$, chaque circuit modulateur permettant d'associer à tout symbole d'entrée $\underline{u}_n^m$ un symbole complexe $z_n^m$ selon une loi de mise en correspondance spécifique.

En outre, une pluralité d'antennes d'émission $\{ta_m\}_{m=1}^{m=\nu}$ est prévue et permet d'assurer l'émission de chaque flux numérique élémentaire codé et constitué en symboles, une antenne d'émission distincte de rang m assurant la transmission du flux numérique élémentaire $EILC⊔DS_m$.

Selon un aspect remarquable du système de codage, l'ensemble des antennes d'émission forme un réseau à diversité spatiale, chaque antenne d'émission $ta_m$ étant distante d'une antenne d'émission voisine $ta_{m'}$, avec $m \neq m'$, d'une distance $d > \lambda_0$, ainsi que mentionné précédemment dans la description, $\lambda_0$ désignant la longueur d'onde de l'onde porteuse assurant la transmission des flux numériques élémentaires précités.

Compte tenu de la constitution de l'ensemble des antennes d'émission en un réseau d'antennes à diversité spatiale, le système permet ainsi d'engendrer un ensemble de flux numériques élémentaires transmis, noté $\{TEILCDSm\}_{m=1}^{m=\nu}$ , lequel présente une diversité spatiale et temporelle, en raison, d'une part, du codage externe introduit par le module de codage 10 et le module d'entrelacement 11 et, d'autre part, du traitement par couches de rang m de chaque trame et de l'émission par chacune des antennes constitutives du réseau d'antennes précité.

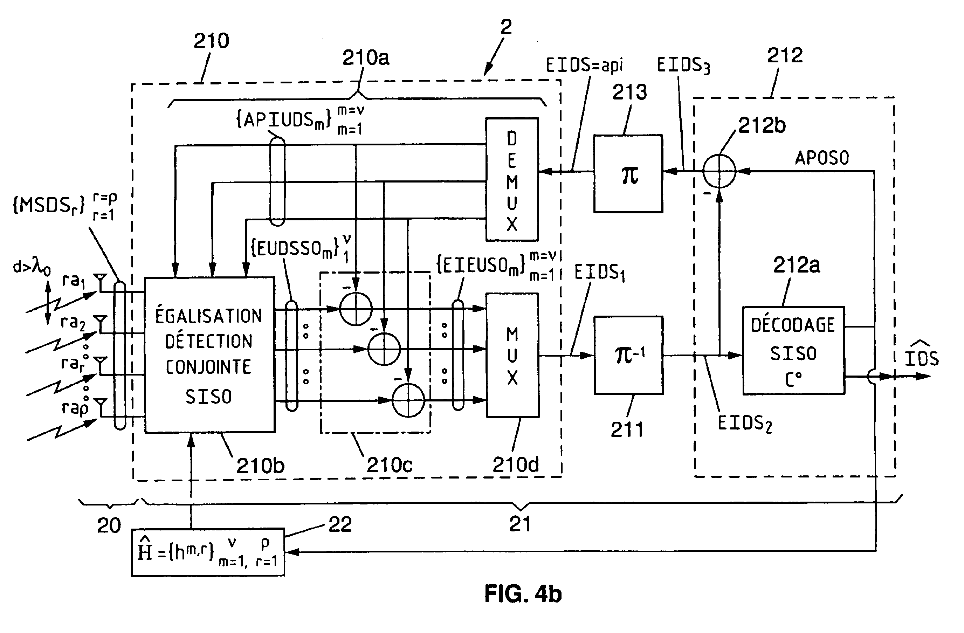

Une description d'un système de décodage d'un flux de données numériques codées avec un entrelacement sur bits, conformément au procédé de codage ci-avant, en émission et en réception multiple, ce flux de données numériques codées consistant au moins en un ensemble de flux numériques élémentaires transmis, noté $\{TEILCDS_m\}_{m=1}^{m=\nu}$ , ainsi que décrit précédemment dans la description, sera maintenant donnée en liaison avec la figure 4b.

En référence à la figure 4b précitée, le système de décodage objet de la présente invention comporte une pluralité d'antennes de réception, notées $\{ra_r\}_{r=1}^{r=\rho}$, ces antennes de réception permettant de recevoir l'ensemble de flux numériques élémentaires transmis par le canal de transmission constitué par l'ensemble des canaux de transmission élémentaires, ainsi que décrit précédemment dans la description.

Selon un aspect remarquable du système de décodage, objet de la présente invention, les antennes de réception précitées peuvent être en nombre inférieur ou égal au nombre ν d'antennes d'émission et forment un réseau d'antennes de réception 20 à diversité spatiale, pour définir un ensemble de flux élémentaires de symboles de modulation reçus, noté $\{MSDS_r\}_{r=1}^{r=\rho}$. Le réseau 20 d'antennes de réception à diversité spatiale est suivi d'un module 21 de turbo-détection des flux élémentaires de symboles de modulation reçus précités par égalisation et détection conjointe itérative, ainsi que décrit précédemment dans la description relativement au procédé de décodage objet de la présente invention.

Ainsi que représenté de manière plus spécifique sur la figure 4b, le module de turbo-détection 21 comporte un module 210 d'égalisation du canal de transmission et de détection conjointe par couches à partir d'un flux d'information extrinsèque sur les bits codés par le premier code externe et entrelacés EIDS=api, ce flux d'information extrinsèque étant issu d'un décodage à partir du code externe C° et constituant une information a priori sur les bits codés précédemment cités. Sur la figure 4b, le flux d'information extrinsèque sur les bits codés par le premier code externe et entrelacés est noté EIDS = api en raison du fait que ce flux constitue en fait une information a priori api sur les bits codés.

Le module 210 d'égalisation du canal de transmission et de détection conjointe permet, à partir des flux élémentaires de symboles de modulation reçus $MSDS_r$, d'engendrer un premier flux d'information extrinsèque $EIDS_1$ sur les bits codés par le code externe et entrelacés. Le module 210 d'égalisation du canal de transmission et de décodage conjoint est suivi d'un module 211 de désentrelacement, noté $\pi^{-1}$, du premier flux d'information extrinsèque $EIDS_1$ afin d'engendrer un deuxième flux d'information extrinsèque sur les bits codés $EIDS_2$ en provenance du module 210 d'égalisation et de détection conjointe.

En outre, un module 212 de décodage à partir du code externe C° est prévu, lequel reçoit le deuxième flux d'information extrinsèque $EIDS_2$ délivré par le module d'entrelacement 211, afin d'engendrer un troisième flux d'information extrinsèque $EIDS_3$ sur les bits codés, ce troisième flux d'information extrinsèque étant issu du décodage à partir du code externe C°.

Bien entendu, le module 212 de décodage à partir du code externe permet d'obtenir une estimée, notée ÎDS, du flux numérique initial IDS transmis, conformément au procédé de codage et grâce au système de codage précédemment décrits dans la description.

Un module 213 d'entrelacement du troisième flux d'information extrinsèque $EIDS_3$ est également prévu, afin d'engendrer le flux d'information extrinsèque sur les bits codés par le premier code externe et entrelacés, noté EIDS = api, constituant l'information a priori sur les bits codés, laquelle est réinjectée dans le module 210 d'égalisation du canal de transmission et de décodage conjoint.

Le système de décodage, objet de la présente invention, tel que représenté en figure 4b, sera maintenant décrit de manière plus détaillée en référence à la même figure dans le cas où l'information a priori sur les bits codés est constituée par une valeur logarithmique du rapport de probabilité extrinsèque des bits codés précités, cette information a priori pouvant en particulier être obtenue lorsque le processus d'égalisation et de détection conjointe est un processus de type SISO, c'est-à-dire à entrée et sortie souples.

En référence à la figure 4b, on indique que le module 210 d'égalisation et de détection conjointe comporte, dans le mode de réalisation précité, un module $210_a$ d'injection de l'information a priori api, comprenant un module démultiplexeur, noté DEMUX, ce module démultiplexeur délivrant, à partir de l'information a priori précitée, constituée par le flux d'information extrinsèque sur les bits codés par le code externe et entrelacés EIDS = api, un ensemble de flux d'information a priori sur les bits des couches de flux numérique codé entrelacés, noté $\{APIDUS_m\}_{m=1}^{m=\nu}$.

On comprend bien entendu qu'afin d'assurer une égalisation et un décodage conjoint par couches, c'est-à-dire par trames et par salves effectivement transmises, ainsi que décrit précédemment dans la description relativement au procédé de codage, le module démultiplexeur DEMUX a pour objet de démultiplexer le flux d'information extrinsèque EIDS sur les bits codés par le code externe et entrelacés, constituant l'information a priori sur les bits codés, sur un même nombre ν de voies de démultiplexage que le nombre de couches de flux numérique codé et entrelacé engendrées à l'émission.

Dans ces conditions, le module 210 d'égalisation et de détection conjointe comporte en outre un module $210_b$ de détection à entrée et sortie pondérée, module SISO, lequel reçoit en entrée, d'une part, le flux d'information a priori sur les bits de trames utilisateur $\{APIDUS_m\}_{m=1}^{m=\nu}$ et, d'autre part, les flux élémentaires de symboles de modulation

reçus $\left\{ \mathrm{MSDS}_r \right\}_{r=1}^{r=\rho}$. Bien entendu, le module $210_b$ de décodage entrées/sorties pondérées reçoit également l'estimée des coefficients du canal de transmission $\hat{H} = \left\{ h^{m,r} \right\}_{m=1,\, r=1}^{\nu \quad \rho}$ des coefficients des canaux de transmission élémentaire, délivrée à partir d'une chaîne de calcul 22 recevant le deuxième flux de sortie pondérée APOSO représentatif de l'information a posteriori sur les bits codés. La chaîne de calcul 22 peut comprendre en cascade un module d'entrelacement $\pi$ et un module de décision non linéaire, suivis d'un module de calcul des coefficients du canal.

Le module de décodage $210_b$ délivre un flux de sorties pondérées sur les bits de couches de flux numérique codé entrelacés, noté $\left\{ \mathrm{EUDSSO}_m \right\}_{m=1}^{m=\nu}$.

Le module $210_b$ est suivi d'une pluralité de modules soustracteurs, notée $210_c$, chaque module soustracteur permettant de soustraire de chaque flux de sorties pondérées sur les bits des couches de flux numérique codé entrelacés $\{EUDSSO_m\}$ l'information a priori sur les bits des couches de flux numérique codé entrelacés $\{APIUDS_m\}$ pour délivrer un flux d'information extrinsèque sur les bits des flux des couches de flux numérique codé entrelacés, noté $\left\{ \mathrm{EIEUSO}_m \right\}_{m=1}^{m=\nu}$.

Un module multiplexeur $210_d$ est alors prévu, ce module multiplexeur recevant les flux d'information extrinsèque $EIEUSO_m$ sur les bits des couches de flux numérique codé entrelacés et délivrant le premier flux d'information extrinsèque sur les bits codés $EIDS_1$ par le code externe et entrelacés au module de désentrelacement 211.

En outre, en référence à la même figure 4a, on indique que le module de décodage 212 à partir du code externe $C^\circ$ peut comprendre un module $212_a$ de détection à entrées/sorties pondérées, recevant le deuxième flux d'information extrinsèque sur les bits codés $EIDS_2$ précité en provenance du processus d'égalisation et de détection conjointe mis en oeuvre par le module 210, le module de décodage à entrées/sorties pondérées $210_a$ délivrant un flux de sorties pondérées représentatif d'une information a priori sur les bits codés APOSO. Le module $212_a$ est associé à un module soustracteur $212_b$ permettant de soustraire le flux de sorties pondérées représentatif d'une information a priori sur les bits codés APOSO, le deuxième flux d'information extrinsèque $EIDS_2$ pour délivrer le troisième flux d'information extrinsèque sur les bits codés $EIDS_3$ issu du décodage à partir du code externe $C^\circ$.

Un justificatif du mode opératoire du module $210_b$ d'égalisation et de détection conjointe de type SISO sera maintenant donné ci-après.

Dans ces conditions, le processus d'égalisation/détection conjointe précité peut être considéré comme un modèle de Markov discret à nombre d'états fini.

Dans ces conditions, le canal équivalent à interférence intersymboles peut être compris comme un code convolutionnel non récursif non systématique de mémoire, exprimée en temps symbole, $\chi_c - 1$, dont le polynôme générateur complexe unique est susceptible de varier dans le temps. Ce dernier, par souci de simplification de dénomination, est désigné par code d'interférence intersymboles.

Chaque couche m constituée par une antenne est ainsi associée à un code d'interférence intersymboles spécifique.

Le code d'interférence intersymboles associé à la couche de rang m est ainsi un modèle de Markov à nombre d'états fini invariable dans le temps et qui admet une représentation en treillis $T^m(V^m, B^m)$ où $V^m$ et $B^m$ désignent l'espace des états ou sommets et l'espace des branches respectivement.

Le treillis $T^m$ est défini à chaque instant d'échantillonnage n par les états ou sommets selon la relation (3) ou (4) :

$$s_n^m = \left\{ z_{n-\chi_c+1}^m, \cdots, z_{n-1}^m \right\} \qquad (3)$$

$z_{n-t}^m$ désignant les symboles complexes successifs, ou de manière équivalente :

$$s_n^m = \left\{ \underline{u}_{n-\chi_c+1}^m, \cdots, \underline{u}_{n-1}^m \right\} \qquad (4)$$

où $\underline{u}_{n-t}^m$ désigne les symboles constitués par les arrangements de bits successifs et par les branches $b_m$. Les branches $b_m$ contiennent trois champs, $b_m = \left\{ b_m^-, b_m^+, b_m^\nabla \right\}$ consistant en :

■ un état de départ $b_m^- \in V_{n-1}$ ;

■ un état d'arrivée $b_m^- \in V_n$ ;

■ une étiquette $b_m^\nabla$ représentant un symbole d'entrée $\underline{u}_n^m$ où $b_m^\nabla = \left\{ b_{m,1}^\nabla, \cdots, b_{m,q+n}^\nabla \right\}$ est la représentation binaire de $\underline{u}_n^m$ .

La complexité de l'espace des états et de l'espace des branches vérifie la relation (5) :

$$\left| V^m \right| = Q_m^{\chi c - 1}, \forall n \in [0, \tau] \quad \text{et} \quad \left| B^m \right| = Q_m^{\chi c}, \forall n \in [1, \tau] \qquad (5).$$

Les considérations précédentes peuvent être généralisées à la totalité de la structure multicouche. Les états et les séquences d'entrée du modèle de Markov résultant correspondent simplement à la concaténation d'états ou de séquences d'entrée des modèles de Markov élémentaires modélisant le code d'interférence intersymboles associé à chaque couche.

Le treillis combiné associé $T^\otimes$ est le produit cartésien $\otimes$ des $\nu$ treillis $\left\{ T^m \right\}_{m=1}^\nu$ . Ainsi, les valeurs de complexité correspondantes sont données par les relations (6) et (7) :

$$\left| V_n^\otimes \right| = \prod_{m=1}^\nu \left| V_n^m \right| \qquad (6)$$

$$\left| B_n^\otimes \right| = \left| V_n^\otimes \right| \cdot \prod_{m=1}^\nu Q_m \qquad (7)$$

où $V_n^\otimes$, $B_n^\otimes$, $V_n^m$ et $B_n^m$, désignent les sommets et les branches des treillis $T^\otimes$ et $T^m$ à toute section $n \in [1, \tau]$.

Dans le but de mettre en oeuvre le processus d'égalisation et de détection conjointe, il est nécessaire de calculer la valeur logarithmique des rapports de probabilité a posteriori de valeur sur chaque bit de chacun des symboles $\underline{u}_n^m$ à chaque instant d'échantillonnage $n \in [1, \tau]$ et pour chaque couche de rang $m \in [1, \nu]$.

Un tel processus calculatoire peut être mis en oeuvre de manière optimale par application de l'algorithme BCJR sur le treillis multicouche résultant $T^\otimes$ ($V^\otimes, B^\otimes$). Les contraintes de calcul et de mémorisation d'un tel algorithme optimum étant sensiblement linéaires en fonction de $|B^\otimes|$, une telle approche se révèle rapidement prohibitive en complexité et ne peut donc être retenue.

Une possibilité pour contourner un tel écueil de complexité consiste à réduire tous les treillis $T^m$ de couche de rang m à des sous-treillis $T^m$ $(V^m, B^m)$ en réduisant la contrainte de longueur $\chi_c$ à une valeur arbitraire inférieure $k_m$, $k_m \in [1, \chi_c]$. La valeur arbitraire $k_m$ peut être adaptée pour chaque couche.

Les sous-états de chaque sous-treillis $T^m$ sont ainsi définis par la relation (8) :

$$s_n^m = \left\{ \underline{u}_{n-k_m+1}^m, \cdots, \underline{u}_{n-1}^m \right\} \qquad (8)$$

et la complexité des espaces d'état et de branche du sous-treillis $T^m$ vérifie la relation (9) :

$$\left| V^m \right| = Q_m^{k_m - 1}, \forall n \in [0, \tau]$$

$$(9)$$

$$\left| B^m \right| = Q_m^{k_m}, \forall n \in [1, \tau]$$

Dans ces conditions, le processus d'égalisation et de détection conjointe multicouche à entrées et sorties pondérées peut être mis en oeuvre selon un concept de traitement par survivant généralisé, lequel sera exposé ci-après.

En raison du fait qu'une partie seulement de la mémoire du code d'interférence intersymboles associé à chaque couche de rang m $\in [1, \nu]$ est maintenue dans le treillis résultant des sous-états, les symboles de modulation transmis $z_n^m$ impliqués dans les métriques euclidiennes de branche et qui ne sont pas directement accessibles doivent être recalculés explicitement grâce à un traitement par survivant, traitement PSP.

Dans le but de limiter l'effet de propagation d'erreur bien connu, le traitement PSP nécessite que les canaux élémentaires de chaque antenne d'émission à toutes les antennes de réception soient des canaux à phase minimale. Malheureusement, il n'est en général pas possible de mettre en oeuvre un filtre de longueur finie à entrées et sorties multiples permettant de satisfaire exactement la contrainte de phase minimale précitée. Un algorithme de Viterbi généralisé, algorithme GVA, a été proposé, dans lequel le concept de base consiste à compenser la dégradation de performance de traitement PSP par la rétention d'un nombre $\Omega$ de chemins survivants supérieur à l'unité par sous-état. Le traitement correspondant est appelé traitement par survivant généralisé ou traitement GPSP.

L'application de l'algorithme GVA à l'égalisation de canal et à la détection conjointe, s'est révélée particulièrement robuste au phénomène de propagation d'erreur. Confer l'article publié par R.VISOZ, A.O.BERTHET, P.TORTELIER "Joint Equalization and Decoding of Trellis-Encoded Signals using the Generalized Viterbi Algorithm", publié par IEEE VTC 2000, Boston, USA.

En particulier, l'approche par traitement GPSP rend la mise en oeuvre d'un préfiltrage à phase minimale non nécessaire.

Différents modes de mise en oeuvre de processus d'égalisation et de détection conjointe de type SISO permettant de bénéficier des avantages du principe du traitement GPSP seront maintenant décrits ci-après.

Une diminution très significative tant en termes de complexité calculatoire que de contraintes de mémorisation peut être obtenue en supprimant le processus de récursion arrière et en réalisant le traitement des sorties souples pendant le processus de récursion avant, ainsi qu'il a été proposé dans l'égaliseur de Viterbi à sorties pondérées SOVE, et dans l'algorithme de Viterbi à sorties pondérées SOVA décrits par G.BAUCH, V.FRANZ dans l'article intitulé "A Comparison of Soft-in and Soft-out Algorithms for Turbo-Detection", Proceedings of ICT vol.2, pp. 259-263, Portos Carras, Greece, Juin 1998, respectivement par J.HAGENAUER, P.HOEHER dans l'article intitulé "A Viterbi Algorithm with Soft-Decision Outputs and its Applications" publié par Proc., IEEE Globecom'89, pp. 1680-1686, Dallas, USA, Novembre 1989.

Les modes de réalisation précités sont désignés algorithme de type SOVE respectivement de type SOVA en référence aux algorithmes SOVE, respectivement SOVA correspondants.

En ce qui concerne l'algorithme de type SOVE, on suppose qu'à toute section n $\in [1, \tau]$, à chaque sous-état de départ $s' \in V_{n-1}^{\otimes}$ sont associés :

■ une liste ordonnée $\left\{\overrightarrow{\mu}_{n-1,\omega}(s'), \omega \in [1,\Omega]\right\}$ des $\Omega$ meilleures métriques accumulées de sous-états en récursion avant ;

■ une liste ordonnée $\left\{\hat{\underline{u}}_{i=n-\theta-1}^{n-1}\Big|_{\omega}^{s'}, \omega \in [1,\Omega]\right\}$ des $\Omega$ trajets survivants correspondants

$$\hat{\underline{u}}_{i=n-\theta-1}^{n-1}\Big|_{\omega}^{s'} = \left\{\hat{\underline{u}}_{n-\theta-1}\Big|_{\omega}^{s'}, \hat{\underline{u}}_{n-\theta}\Big|_{\omega}^{s'}, \cdots, \hat{\underline{u}}_{n-1}\Big|_{\omega}^{s'}\right\}$$ se terminant en s'.

L'algorithme de type SOVA requiert également :

■ une liste ordonnée $\left\{\hat{\underline{L}}_{i=n-\theta-1}^{n-1}\Big|_{\omega}^{s'}, \omega \in [1,\Omega]\right\}$ des $\Omega$ séquences bits pondérées non signées

$$\hat{\underline{L}}_{i=n-\theta-1}^{n-1}\Big|_{\omega}^{s'} = \left\{\hat{\underline{L}}_{n-\theta-1}\Big|_{\omega}^{s'}, \hat{\underline{L}}_{n-\theta}\Big|_{\omega}^{s'}, \cdots, \hat{\underline{L}}_{n-1}\Big|_{\omega}^{s'}\right\}$$

associées aux trajets survivants.

Les algorithmes de type SOVE et SOVA généralisés à sens de récursion unique exécutent une récursion avant, à la profondeur n, pour chaque sous-état de terminaison $s \in V_n^{\otimes}$ , calculent pour toutes les transitions $b \in B_n^{\otimes}$ telles que b⁺ = s et pour tous les rangs $\omega \in [1,\Omega]$, les nouvelles métriques accumulées de sous-états selon la relation (10) :

$$\mu_{\bar{n},*}(s) = \mu_{\bar{n}-1,\ell}(b^-) + \xi_{n,\ell}(b)$$

avec
$$(10)$$

$$\xi_{n,\omega}(b) = \frac{1}{2\sigma^2}\sum_{r=1}^{\rho}\left\|y_n^r - \sum_{m=1}^{\nu}\sum_{i=0}^{\chi_c-1}\hat{h}_i^{m,r}\hat{z}_{n-i}^m\Big|_{\omega}^{b^-}\right\|^2 - \sum_{(m,j)}\ell n\,Pr(b_{m,j}^{\nabla})$$

$\ell$n désignant le logarithme népérien.

Ces métriques sont ensuite classifiées par ordre de valeur croissante. Cette récursion est exécutée avec les conditions aux limites données par la relation (11) :

$$\mu_{\bar{0},1}(0) = 0; \mu_{\bar{0},\omega}(0) = \infty \quad \text{pour } \omega > 1 \qquad (11)$$

et $\mu_{\bar{0},\omega}(s) = \infty, \forall s \neq 0, \omega \in [1,\Omega]$ .

Seules les $\Omega$ meilleures métriques, les plus faibles, sont mémorisées au niveau du sous-état s pour l'étape de la section suivante.

Simultanément, les trajets survivants passés $\hat{\underline{u}}_{i=n-\theta-1}^{n-1}\Big|_{\omega}^{s'}$ , $\omega \in [1,\Omega]$ sont étendus selon les transitions existantes

s': $\underline{u}_n \rightarrow$ s. Les $\Omega \times \prod_{m=1}^{\nu} Q_m$ nouveaux trajets survivants potentiels $\hat{\underline{u}}_{i=n-\theta}^{n}\Big|_{\omega}^{s'}$ sont mémorisés temporairement et triés selon le rang de leur métrique associée $\mu_{\bar{n},\omega}(s)$ mais seuls les $\Omega$ trajets survivants dont les métriques sont les meilleures sont effectivement utilisés pour l'étape de la section suivante.

L'algorithme de type SOVE généralisé calcule la valeur logarithmique du rapport de probabilité extrinsèque de la valeur bit $u_{n-\theta,j}^{m}$ selon la relation (12) :

$$\lambda^e\left(u_{n-\theta,j}^{m}\right)=\min_{1\leq\omega\leq\Omega}\left\{\min_{b\in B_n^{\otimes},\ \hat{u}_{n-\theta,j}^{m}\ b^-=0}\left\{\vec{\mu}_{n-1,\omega}(b^-)+\xi_{n,\omega}^{e,j}(b)\right\}\right\}$$

$$- \min_{1\leq\omega\leq\Omega}\left\{\min_{b\in B_n^{\otimes},\ \hat{u}_{n-\theta,j}^{m}\ b^-=1}\left\{\vec{\mu}_{n-1,\omega}(b^-)+\xi_{n,\omega}^{e,j}(b)\right\}\right\}$$

$$(12)$$

relation qui, en pratique, se réduit à la relation (13) :

$$\lambda^e\left(u_{n-\theta,j}^{m}\right)=\lambda\left(u_{n-\theta,j}^{m}\right)-\lambda^p\left(u_{n-\theta,j}^{m}\right) \qquad (13)$$

où $\lambda\left(u_{n-\theta,j}^{m}\right)$ est une valeur approchée du logarithme du rapport des probabilités a posteriori des valeurs du bit $u_{n-\theta,j}^{m}$ définie par la relation (14) :

$$\lambda\left(u_{n-\theta,j}^{m}\right)=\min_{1\leq\omega\leq\Omega}\left\{\min_{b\in B_n^{\otimes},\ \hat{u}_{n-\theta,j}^{m}\ b^-=0}\left\{\vec{\mu}_{n-1,\omega}(b^-)+\xi_{n,\omega}(b)\right\}\right\}$$

$$(14)$$

$$- \min_{1\leq\omega\leq\Omega}\left\{\min_{b\in B_n^{\otimes},\ \hat{u}_{n-\theta,j}^{m}\ b^-=1}\left\{\vec{\mu}_{n-1,\omega}(b^-)+\xi_{n,\omega}(b)\right\}\right\}$$

et où $\lambda^p\left(u_{n-\theta,j}^{m}\right)$ est une valeur du logarithme du rapport des probabilités de la valeur du bit $u_{n-\theta,j}^{m}$ égale à 1, respectivement à zéro issue du décodage au moyen du code externe C° vérifiant la relation (15) :

$$\lambda^p\left(u_{n-\theta,j}^{m}\right)=\ell n\ \frac{Pr\left(u_{n-\theta,j}^{m}=1\right)}{Pr\left(u_{n-\theta,j}^{m}=0\right)} \qquad (15)$$

L'algorithme de type SOVA généralisé opère de manière légèrement différente.

De manière semblable aux trajets survivants, les séquences pondérées non signées d'information bit $\underline{\hat{L}}_{i=n-\theta-1}^{n-1}{}_{\omega}^{s'}$, $\omega$ [1,$\Omega$] sont tout d'abord étendues selon des transitions existantes s':$\underline{u}_n \rightarrow$s.

Les $\Omega \mathbf{x} \prod_{m=1}^{\nu} Q_m$ nouvelles séquences pondérées non signées potentielles $\underline{\hat{L}}_{i=n-\theta}^{n}{}_{*}^{s}$ sont mémorisées temporairement et triées en fonction du rang des métriques $\mu_{n,*}^{\rightarrow}(s)$ correspondantes. Pour chaque couche m $\in$ [1,$\nu$] et pour chaque bit d'entrée d'un symbole j $\in$ [1, $q_m$] les séquences pondérées non signées $\hat{L}_{n,j}^{m}{}_{\omega}^{s}$ sont initialisées selon la relation (16) :

$$\hat{L}_{n,j}^{m}{}_{\omega}^{s} = \infty \qquad (16)$$

A nouveau, les $\Omega$ meilleures séquences pondérées non signées sont seules mémorisées pour l'étape de section suivante. L'étape de décision pondérée de mise à jour de l'algorithme est ensuite exécutée.

Pour tout sous-état $s \in V_n^{\otimes}$, pour chaque couche m $\in$ [1,$\nu$], pour chaque bit d'entrée j $\in$ [1,$q_m$] et pour chaque rang $\omega \in$ [1,$\Omega$], les séquences pondérées non signées d'information sur la valeur des bits $\underline{\hat{L}}_{i=n-\theta}^{n}{}_{\omega}^{s}$ sont mises à jour par récursion descendante de la profondeur i = n-1 à la profondeur i = n-$\delta$ selon la relation (17) :

$$\hat{L}_{i,j}^{m}{}_{\omega}^{s} = f\left(\hat{L}_{i,j}^{m}{}_{\omega}^{s}, \Delta_{n,j}^{m}{}_{\omega}^{s}\right) \qquad (17)$$

relation dans laquelle f(.) est une fonction de mise à jour et où :

$$\Delta_{n,j}^{m}{}_{\omega}^{s} = \mu_{n,\overline{\omega}_{i,j}^{m}}^{\rightarrow}(s) - \mu_{n,\omega}^{\rightarrow}(s) \qquad (18)$$

avec

$$\overline{\omega}_{i,j}^{m} = \min\left\{ \ell \geq \Omega + 1, \hat{u}_{i,j}^{m}{}_{\ell}^{s} \neq \hat{u}_{i,j}^{m}{}_{\omega}^{s} \right\} \qquad (19)$$

Selon un mode de mise en oeuvre spécifique, la fonction de mise à jour f(.) peut avantageusement vérifier la relation (20) :

$$f\left(\hat{L}_{i,j}^{m}{}_{\omega}^{s}, \Delta_{n,j}^{m}{}_{\omega}^{s}\right) = \ell n \frac{1 + \exp\left(\hat{L}_{i,j}^{m}{}_{\omega}^{s} + \Delta_{n,j}^{m}{}_{\omega}^{s}\right)}{\exp\left(\hat{L}_{i,j}^{m}{}_{\omega}^{s}\right) + \exp\left(\Delta_{n,i}^{m}{}_{\omega}^{s}\right)} \qquad (20)$$

et peut être établie selon une expression approchée vérifiant la relation (21) :

$$f\left(\hat{L}^{m}_{i,j}\,^{s}_{\omega}, \Delta^{m}_{n,j}\,^{s}_{\omega}\right) \approx \min\left\{\hat{L}^{m}_{i,j}\,^{s}_{\omega}, \Delta^{m}_{n,j}\,^{s}_{\omega}\right\} \qquad (21)$$

Pour $n \geq \theta$, l'algorithme délivre des valeurs pondérées signées d'information sur le bits du symbole $\underline{u}_{n-\theta}$. Ces valeurs pondérées signées :

$$\lambda\left(u^{m}_{n-\theta,j}\right) = \left(2 \times \hat{u}^{m}_{n-\theta,j}\,^{sbest}_{1} - 1\right) \times \hat{L}^{m}_{n-\theta,j}\,^{sbest}_{1} \qquad (22)$$

sont calculées pour $m \in [1, \nu]$ $j \in [1,q_m]$ en utilisant le trajet survivant de premier rang $\hat{\underline{u}}^{n}_{i=n-\theta}\,^{sbest}_{1}$ et la séquence de valeurs pondérées signées d'information sur les bits $\hat{\underline{L}}^{n}_{i=n-\theta}\,^{sbest}_{1}$ qui se terminent chacun, à la section n, dans le sous-état sbest.

Le sous-état sbest est défini selon la relation (23) :

$$sbest = \arg\min\left\{\overrightarrow{\mu}_{n,1}(s), s \in V^{\otimes}_{n}\right\} \qquad (23).$$

En définitive, une valeur approchée directement utilisable de la valeur du logarithme du rapport des probabilités de la valeur des bits $u^{m}_{n-\theta,j}$ est calculée par une soustraction pour chaque bit de la valeur du logarithme du rapport des probabilités a priori de la valeur du bit $\lambda^{a}\left(u^{m}_{n-\theta,j}\right) = \mathrm{APOSO}$ délivrée par le décodeur externe 212a aux valeurs pondérées signées obtenues $\lambda\left(u^{m}_{n-\theta,j}\right) = \mathrm{EIDS_2}$ selon la relation (24) :

$$\lambda^{e}\left(u^{m}_{n-\theta,j}\right) = \lambda\left(u^{m}_{n-\theta,j}\right) - \lambda^{a}\left(u^{m}_{n-\theta,j}\right) \qquad (24).$$

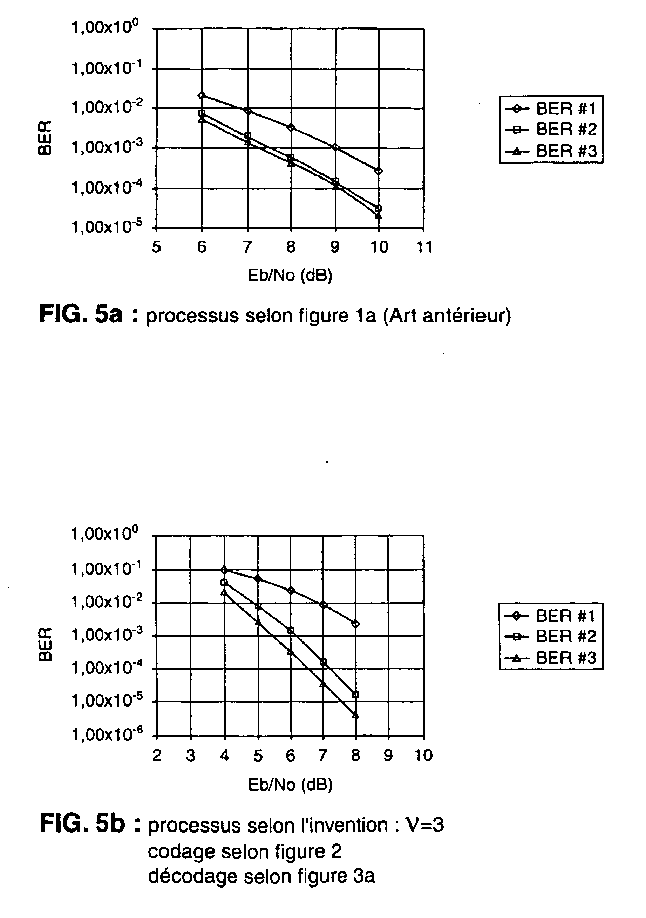

Les figures 5a à 5d représentent des diagrammes de simulation de la valeur du taux d'erreur bit au décodage, BER, en fonction du rapport signal à bruit Eb/No exprimé en dB et des itérations successives dans différentes situations. Le canal de test était constitué par un canal normalisé de type $EQ_3$, c'est-à-dire un canal constitué par trois échos séparés du temps symbole, chaque écho suivant une distribution de Rayleigh. En outre, le code externe C° était un code convolutif de rendement 1/2 à 16 états et le processus d'entrelacement avait pour taille 128 x 8 bits.

La figure 5a représente une telle simulation dans le cas de la mise en oeuvre d'un processus de l'art antérieur selon la figure 1a. Le treillis du processus d'égalisation dans ce cas correspondait à un treillis à 64 états. On observe que le taux d'erreur bit BER atteint la valeur $1,00 \times 10^{-4}$ pour un rapport signal à bruit de valeur 9 dB à la troisième itération #3.

La figure 5b correspond à un processus de codage/décodage conforme à l'objet de la présente invention dans lequel le nombre de couches $\nu=3$. Dans cette situation, le treillis correspondant au processus d'égalisation et de détection conjointe comportait également 64 états et un seul trajet survivant, soit $\Omega = 1$. On constate, en particulier, une valeur du taux d'erreur bit du même ordre de grandeur BER = $1,00 \times 10^{-4}$ alors que le rapport signal à bruit n'est que de 7 dB dès, la deuxième itération #2.

La figure 5c correspond à un processus de codage / décodage conforme à l'objet de la présente invention exécuté dans les conditions semblables à celles de la figure 5b, le nombre de couches $\nu$ ayant cependant été porté à v=4. En outre, le treillis du processus d'égalisation et de détection conjointe comportait un nombre d'états égal à 16 et le nombre de trajets survivants retenus était $\Omega = 8$.

Alors que les performances, dans cette situation, restent largement supérieures à celles de l'art antérieur, représenté en figure 5a, tant en matière de réduction du taux d'erreur bit que de vitesse de convergence, la seule augmentation du nombre de couches n'apparaît pas en mesure d'améliorer cet ensemble de critères vis-à-vis du processus objet de l'invention décrit en figure 5b.

Enfin, la figure 5d correspond à un processus de codage / décodage conforme à l'objet de l'invention, le nombre de couches étant pris égal à v=3, pour différentes valeurs du nombre $\Omega$ de trajets survivants retenus, comparé à un processus de décodage optimal de type BCJR. Alors que le processus d'égalisation et de détection conjointe BCJR comportait 64 états, le nombre d'états du processus de type SOVA, désigné SOVA like, était restreint à 8 états, le nombre $\Omega$ de trajets survivants, pris comme paramètre d'essai, ayant été porté successivement de $\Omega = 1$ à $\Omega = 4$.

On constate que, pour un nombre de trajets survivants retenus $\Omega = 4$, dès la troisième itération, les performances en matière de taux d'erreur bit sont très proches de celles du décodage optimal BCJR, quelle que soit sensiblement la valeur du rapport signal à bruit.

Le système de décodage selon l'invention utilise ainsi un algorithme sous-optimal pour réaliser les opérations de détection multicouches et de décodage d'interférences intersymboles, en réduisant avantageusement la complexité des traitements effectués. En outre, il met en oeuvre une estimation itérative des coefficients de la réponse impulsionnelle des canaux de transmission.

Le procédé de codage et de décodage objet de la présente invention donne des résultats particulièrement intéressants en matière de gain de taux d'erreur bit pour de larges plages de valeurs du rapport signal à bruit. Il peut en outre être optimisé en fonction du nombre de couches et du nombre de trajets survivants retenus.

**Revendications**

1. Procédé de décodage d'un flux de données numériques codées avec entrelacement sur bits en émission et en réception multiple sur un canal de transmission générateur d'interférences intersymboles, ce flux de données numériques codées avec entrelacement consistant en un ensemble de flux numériques élémentaires transmis obtenus à partir d'un flux initial de données numériques soumis à :

   - un codage externe (A) au moyen d'un code de rendement déterminé, pour engendrer un flux numérique codé,
   - un entrelacement (B) au niveau bit de ce flux numérique codé pour engendrer un flux numérique codé entrelacé,
   - un démultiplexage (C) de couche de ce flux numérique codé entrelacé sur un nombre v de voies démultiplexées déterminé, pour engendrer un nombre correspondant de couches de flux numérique codé entrelacé,
   - une conversion (D) de chaque suite numérique de modulation constituée par $q_m$ bits successifs d'une même couche en un symbole $Q_m$-aire, $Q_m = 2^{q_m}$, selon un schéma de mise en correspondance spécifique,
   - une transmission (E) de chaque symbole $Q_m$-aire au moyen d'une antenne d'émission distincte, l'ensemble de ces antennes formant un réseau à diversité spatiale, permettant d'engendrer cet ensemble de flux numériques élémentaires transmis,

   **caractérisé en ce que** ledit procédé consiste :

   - à recevoir (F), sur une pluralité $\rho$ d'antennes de réception, ledit flux de données numériques codées avec entrelacement sur bits en émission et en réception multiple constitué par ledit ensemble de flux numériques élémentaires transmis sur ce canal de transmission, lesdites antennes de réception étant en nombre $\rho$ indépendant du nombre v d'antennes d'émission et formant un réseau d'antennes de réception à diversité spatiale pour définir un ensemble de flux élémentaires de symboles de modulation reçus ;
   - à soumettre ledit ensemble de flux élémentaires de symboles de modulation reçus à un processus itératif (G) d'égalisation du canal de transmission et de détection conjointe multicouche au moyen d'un flux d'information extrinsèque sur les bits codés par ledit code externe et entrelacés, ledit flux d'information extrinsèque constituant une information a priori, pour engendrer un premier flux d'information extrinsèque sur les bits codés par le code externe et entrelacés ;
   - à soumettre ledit premier flux d'information extrinsèque à un désentrelacement (H), pour engendrer un deuxième flux d'information extrinsèque sur les bits codés en provenance du processus d'égalisation ;
   - à soumettre ledit deuxième flux d'information extrinsèque sur les bits codés à un décodage (I) à partir dudit code externe, pour engendrer un troisième flux d'information extrinsèque sur les bits codés, issu du décodage à partir dudit code externe ;
   - à soumettre ledit troisième flux d'information extrinsèque à un entrelacement (J), pour engendrer ledit flux d'information extrinsèque sur les bits codés par ledit code externe et entrelacés constituant ladite information a priori ;
- à réinjecter (K) ladite information a priori dans le processus itératif d'égalisation du canal de transmission et de détection conjointe multicouche ;

ledit processus itératif d'égalisation et de détection conjointe du canal de transmission consistant :

- à soumettre ledit flux d'information extrinsèque sur les bits codés par ledit code externe et entrelacés, constituant ladite information a priori, à un démultiplexage de couche en un ensemble $\nu$ de flux d'information a priori sur les bits des couches de flux numérique codé entrelacé ;
- à effectuer, sur lesdits flux élémentaires de symboles de modulation reçus, à partir desdits flux d'information a priori sur les bits des couches, une égalisation et une détection conjointe multicouche à entrée/sortie pondérée appliquée à un treillis global réduit en nombre d'états, ce treillis étant défini comme le treillis des canaux à mémoire élémentaires constitutifs du canal de transmission, ledit treillis global résultant d'un produit cartésien de treillis réduits en nombre d'états, associés aux canaux, les treillis étant réduits en nombre d'états en réduisant la contrainte de longueur à une valeur arbitraire inférieure, pour engendrer un ensemble de flux de sorties pondérées sur les bits de couches de flux numérique codé entrelacé ;
- à extraire de chaque flux de sorties pondérées sur les bits de couche ladite information a priori sur les bits de couche, pour engendrer un ensemble de flux d'information extrinsèque sur les bits de couche ;
- à soumettre l'ensemble de flux d'information extrinsèque sur les bits de couche à un multiplexage, pour engendrer ledit premier flux d'information extrinsèque sur les bits codés par le code externe et entrelacés,
le procédé étant en outre, **caractérisé en ce que** l'étape d'égalisation et de détection conjointe multicouche à entrée et sortie pondérée est mise en oeuvre par le processus GPSP, consistant à conserver $\Omega$ survivants par noeud du treillis réduit global, le calcul des dites sorties pondérées consistant en un processus SOVA généralisé.

2. Procédé selon la revendication 1, **caractérisé en ce que** ledit décodage (I) au moyen dudit code externe consiste :

- à soumettre ledit deuxième flux d'information extrinsèque sur les bits codés en provenance du processus d'égalisation à un décodage à entrée/sortie pondérée au moyen dudit code externe, pour engendrer un flux de sorties pondérées représentatives d'une information a posteriori sur les bits codés ;
- à soustraire ledit deuxième flux d'information extrinsèque dudit flux de sorties pondérées représentatives de ladite information a posteriori sur les bits codés, pour engendrer ledit troisième flux d'information extrinsèque sur les bits codés.

3. Procédé selon l'une des revendications 1 et 2, **caractérisé en ce que** pour un ensemble de flux numériques élémentaires transmis constitué par des salves comportant au moins une suite de symboles binaires d'apprentissage, celui-ci consiste en outre à :

- calculer pour chaque itération à partir de symboles d'apprentissage une estimation des coefficients de contribution à l'interférence intersymboles entre canaux élémentaires constitutifs du canal de transmission ;
- réinjecter dans le processus d'égalisation et de détection conjointe multicouche les valeurs réestimées de ces coefficients.

4. Dispositif de décodage d'un flux de données numériques codées avec entrelacement sur bits en émission et en réception multiple sur un canal de transmission générateur d'interférences intersymboles, ce flux de données numériques codées avec entrelacement consistant en un ensemble de données numériques soumis à :

- un codage (A, B) externe au moyen d'un code de rendement déterminé, pour engendrer un flux numérique codé entrelacé,
- un démultiplexage de couche (C) de ce flux numérique codé entrelacé sur un nombre $\nu$ de voies démultiplexées déterminé, pour engendrer un nombre correspondant de couches de flux numérique codé entrelacé,
- une conversion (D) de chaque suite numérique de modulation constituée par $q_m$ bits successifs d'une même couche en un symbole $Q_m$-aire, $Q_m = 2^{q_m}$, selon un schéma de mise en correspondance spécifique,
- une transmission (E) de chaque symbole $Q_m$-aire au moyen d'une antenne d'émission distincte, l'ensemble de ces antennes formant un réseau à diversité spatiale, permettant d'engendrer cet ensemble de flux numériques élémentaires transmis,

**caractérisé en ce que** ledit dispositif de décodage comporte :

- une pluralité ρ d'antennes de réception permettant de recevoir (F) ledit flux de données numériques codées avec entrelacement sur bits en émission et en réception multiple constitué par ledit ensemble de flux numériques élémentaires transmis sur ce canal de transmission, lesdites antennes de réception étant en nombre ρ indépendant du nombre ν d'antennes d'émission et formant un réseau d'antennes de réception à diversité spatiale permettant de définir un ensemble de flux élémentaires de symboles de modulation reçus ;

- des moyens de turbodétection permettant de soumettre ledit ensemble de flux élémentaires de modulation reçus à un processus itératif (G) d'égalisation du canal de transmission et de détection conjointe multicouche au moyen d'un flux d'information extrinsèque sur les bits codés par ledit code externe et entrelacés, ledit flux d'information extrinsèque constituant une information a priori, pour engendrer un premier flux d'information extrinsèque sur les bits codés par le code externe et entrelacés ;

- des moyens de désentrelacement recevant ledit premier flux d'information extrinsèque et permettant, par désentrelacement (H) de ce dernier, d'engendrer un deuxième flux d'information extrinsèque sur les bits codés en provenance du processus d'égalisation ;

- des moyens décodeurs recevant ledit deuxième flux d'information extrinsèque sur les bits codés et permettant, par décodage (I) de ce dernier à partir dudit code externe, d'engendrer un troisième flux d'information extrinsèque sur les bits codés, issu du décodage à partir dudit code externe ;

- des moyens d'entrelacement recevant ledit troisième flux d'information extrinsèque et permettant, par entrelacement (J), d'engendrer ledit flux d'information extrinsèque sur les bits codés par ledit code externe et entrelacés constituant ladite information a priori ;

- des moyens de réinjection de ladite information a priori dans le processus itératif d'égalisation du canal de transmission et de détection conjointe multicouche ;

lesdits moyens de turbodétection comportant :

- des moyens de démultiplexage de couche recevant ledit flux d'information extrinsèque sur les bits codés par ledit code externe et entrelacés constituant ladite information a priori permettant, par démultiplexage sur un nombre ν de voies, d'engendrer un ensemble ν de flux d'information a priori sur les bits des couches de flux numérique codé entrelacé ;

- des moyens d'égalisation et de détection conjointe multicouche recevant, d'une part, lesdits flux élémentaires de symboles de modulation reçus, et, d'autre part, lesdits flux d'information a priori sur les bits des couches, lesdits moyens d'égalisation et de détection conjointe permettant d'effectuer une égalisation et une détection conjointe multicouche à entrée/sortie pondérée appliquée à un treillis global réduit en nombre d'états, ce treillis étant défini comme le treillis des canaux à mémoire élémentaires constitutifs du canal de transmission, ledit treillis global résultant d'un produit cartésien de treillis réduits en nombre d'états, associés aux canaux, les treillis étant réduits en nombre d'états en réduisant la contrainte de longueur à une valeur arbitraire inférieure, pour engendrer un ensemble de flux de sorties pondérées sur les bits de couches de flux numérique codé entrelacé ;

- des moyens d'extraction, de chaque flux de sorties pondérées sur les bits de couches de flux numérique codé entrelacé ;

- des moyens d'extraction, de chaque flux de sorties pondérées sur les bits de couche, de ladite information a priori sur les bits de couche, permettant d'engendrer un ensemble de flux d'information extrinsèque sur les bits de couche ;

- des moyens multiplexeurs recevant ledit ensemble de flux d'information extrinsèque sur les bits de couche et permettant, par multiplexage, d'engendrer ledit premier flux d'information extrinsèque sur les bits codés par le code externe et entrelacés,

le dispositif étant en outre **caractérisé en ce que** lesdits moyens d'égalisation et de détection conjointe multicouche à entrée et sortie pondérée sont mis en oeuvre selon un processus GPSP consistant à conserver $\Omega$ trajets survivants par noeud du treillis réduit global, le calcul desdites sorties pondérées consistant en un processus de type SOVA/ SOVE généralisé.

**5.** Dispositif selon la revendication 4, **caractérisé en ce que en ce que** lesdits moyens décodeurs comportent :

- des moyens de décodage à entrée/sortie pondérée au moyen dudit code externe recevant ledit deuxième flux d'information extrinsèque sur les bits codés en provenance du processus d'égalisation et permettant d'engendrer un flux de sorties pondérées représentatives d'une information a posteriori sur les bits codés ;

- des moyens soustracteurs dudit deuxième flux d'information extrinsèque dudit flux de sorties pondérées représentatives de ladite information a posteriori sur les bits codés, permettant d'engendrer ledit troisième flux d'information extrinsèque sur les bits codés.

**6.** Dispositif selon l'une des revendications 4 et 5. **caractérisé en ce que**, pour un ensemble de flux numériques élémentaires transmis constitué par des salves comportant au moins une suite de symboles binaires d'apprentissage, celui-ci comprend en outre des moyens de calcul, pour chaque itération, à partir desdits symboles d'apprentissage d'une estimation des coefficients de contribution à l'interférence intersymboles entre canaux élémentaires constitutifs du canal de transmission, les valeurs réestimées de ces coefficients étant réinjectées dans le processus d'égalisation et de détection.

## Claims

**1.** Method for decoding a stream of digital data coded with bit-interleaving in multiple send and receive on a transmission channel generating intersymbol interference, this stream of digital data coded with interleaving consisting of a set of transmitted elementary digital streams obtained on the basis of an initial stream of digital data subjected to:

  - an external coding (A) by means of a determined rate code, so as to produce a coded digital stream,
  - an interleaving (B) at the bit level of this coded digital stream so as to produce an interleaved coded digital stream,
  - a layer demultiplexing (C) of this interleaved coded digital stream on a determined number $\nu$ of demultiplexed pathways, so as to produce a corresponding number of layers of interleaved coded digital stream,
  - a conversion (D) of each digital modulation string consisting of $q_m$ successive bits of one and the same layer into a $Q_m$-ary symbol, $Q_m = 2^{q_m}$, according to a specific mapping scheme,
  - a transmission (E) of each $Q_m$-ary symbol by means of a distinct send antenna, the set of these antennas forming a spatial-diversity array, making it possible to produce this set of transmitted elementary digital streams,

**characterized in that** said method consists:

  - in receiving (F), on a plurality $\rho$ of receive antennas, said stream of digital data coded with bit-interleaving in multiple send and receive consisting of said set of elementary digital streams transmitted on this transmission channel, said receive antennas being in number $\rho$ independent of the number $\nu$ of send antennas and forming an array of spatial-diversity receive antennas so as to define a set of elementary streams of modulation symbols received;
  - in subjecting said set of elementary streams of modulation symbols received to an iterative process (G) of equalization of the transmission channel and of multilayer joint detection by means of a stream of extrinsic information on the bits coded by said external code and interleaved, said stream of extrinsic information constituting a priori information, so as to produce a first stream of extrinsic information on the bits coded by the external code and interleaved;
  - in subjecting said first stream of extrinsic information to a deinterleaving (H), so as to produce a second stream of extrinsic information on the coded bits originating from the equalization process;
  - in subjecting said second stream of extrinsic information on the coded bits to a decoding (I) on the basis of said external code, so as to produce a third stream of extrinsic information on the coded bits, arising from the decoding on the basis of said external code;
  - in subjecting said third stream of extrinsic information to an interleaving (J), so as to produce said stream of extrinsic information on the bits coded by said external code and interleaved constituting said a priori information;
  - in reinjecting (K) said a priori information into the iterative process of equalization of the transmission channel and of multilayer joint detection; said iterative process of equalization and of joint detection of the transmission channel consisting:
  - in subjecting said stream of extrinsic information on the bits coded by said external code and interleaved, constituting said a priori information, to a layer demultiplexing into a set $\nu$ of streams of a priori information on the bits of the layers of interleaved coded digital stream;
  - in performing, on said elementary streams of modulation symbols received, on the basis of said streams of a priori information on the bits of the layers, an equalization and a multilayer joint detection with weighted input/output applied to a global trellis that is reduced in terms of number of states, this trellis being defined as the trellis of the constituent elementary memory channels of the transmission channel, said global trellis resulting from a cartesian product of trellises that are reduced in terms of number of states, associated with the channels, the trellises being reduced in terms of number of states by reducing the length constraint to a lower arbitrary value, so as to produce a set of streams of weighted outputs on the bits of layers of interleaved coded digital stream;

- in extracting from each stream of weighted outputs on the layer bits said a priori information on the layer bits, so as to produce a set of streams of extrinsic information on the layer bits;
- in subjecting the set of streams of extrinsic information on the layer bits to a multiplexing, so as to produce said first stream of extrinsic information on the bits coded by the external code and interleaved,

the method being furthermore **characterized in that** the step of equalization and of multilayer joint detection with weighted input and output is implemented by the GPSP process, consisting in preserving $\Omega$ survivors per node of the global reduced trellis, the calculation of said weighted outputs consisting of a generalized SOVA process.

2. Method according to Claim 1, **characterized in that** said decoding (I) by means of said external code consists:

- in subjecting said second stream of extrinsic information on the coded bits originating from the equalization process to a decoding with weighted input/output by means of said external code, so as to produce a stream of weighted outputs that are representative of a posteriori information on the coded bits;
- in subtracting said second stream of extrinsic information from said stream of weighted outputs that are representative of said a posteriori information on the coded bits, so as to produce said third stream of extrinsic information on the coded bits.

3. Method according to one of Claims 1 and 2, **characterized in that** for a set of transmitted elementary digital streams consisting of bursts comprising at least one string of binary learning symbols, it furthermore consists in:

- calculating for each iteration on the basis of learning symbols an estimation of the coefficients of contribution to the intersymbol interference between constituent elementary channels of the transmission channel;
- reinjecting the re-estimated values of these coefficients into the equalization and multilayer joint detection process.

4. Device for decoding a stream of digital data coded with bit-interleaving in multiple send and receive on a transmission channel generating intersymbol interference, this stream of digital data coded with interleaving consisting of a set of digital data subjected to:

- an external coding (A, B) by means of a determined rate code, so as to produce an interleaved coded digital stream,
- a layer demultiplexing (C) of this interleaved coded digital stream on a determined number $\nu$ of demultiplexed pathways, so as to produce a corresponding number of layers of interleaved coded digital stream,
- a conversion (D) of each digital modulation string consisting of $q_m$ successive bits of one and the same layer into a $Q_m$-ary symbol, $Q_m = 2^{qm}$, according to a specific mapping scheme,
- a transmission (E) of each $Q_m$-ary symbol by means of a distinct send antenna, the set of these antennas forming a spatial-diversity array, making it possible to produce this set of transmitted elementary digital streams,

**characterized in that** said decoding device comprises:

- a plurality $\rho$ of receive antennas making it possible to receive (F) said stream of digital data coded with bit-interleaving in multiple send and receive consisting of said set of elementary digital streams transmitted on this transmission channel, said receive antennas being in number $\rho$ independent of the number $\nu$ of send antennas and forming an array of spatial-diversity receive antennas making it possible to define a set of elementary streams of modulation symbols received;
- turbodetection means making it possible to subject said set of elementary modulation streams received to an iterative process (G) of equalization of the transmission channel and of multilayer joint detection by means of a stream of extrinsic information on the bits coded by said external code and interleaved, said stream of extrinsic information constituting a priori information, so as to produce a first stream of extrinsic information on the bits coded by the external code and interleaved;
- deinterleaving means receiving said first stream of extrinsic information and making it possible, by deinterleaving (H) of the latter, to produce a second stream of extrinsic information on the coded bits originating from the equalization process;
- decoder means receiving said second stream of extrinsic information on the coded bits and making it possible, by decoding (I) of said stream on the basis of said external code, to produce a third stream of extrinsic information on the coded bits, arising from the decoding on the basis of said external code;
- interleaving means receiving said third stream of extrinsic information and making it possible, by interleaving (J), to produce said stream of extrinsic information on the bits coded by said external code and interleaved constituting said a priori information;
- means for reinjecting said a priori information into the iterative process of equalization of the transmission channel and of multilayer joint detection; said turbodetection means comprising:
- layer demultiplexing means receiving said stream of extrinsic information on the bits coded by said external code and interleaved constituting said a priori information making it possible, by demultiplexing on a number ν of pathways, to produce a set ν of streams of a priori information on the bits of the layers of interleaved coded digital stream;
- equalization and multilayer joint detection means receiving, on the one hand, said elementary streams of modulation symbols received, and, on the other hand, said streams of a priori information on the bits of the layers, said equalization and joint detection means making it possible to perform an equalization and a multilayer joint detection with weighted input/output applied to a global trellis that is reduced in terms of number of states, this trellis being defined as the trellis of the constituent elementary memory channels of the transmission channel, said global trellis resulting from a cartesian product of trellises that are reduced in terms of number of states, associated with the channels, the trellises being reduced in terms of number of states by reducing the length constraint to a lower arbitrary value, so as to produce a set of streams of weighted outputs on the bits of layers of interleaved coded digital stream;
- means for extracting, from each stream of weighted outputs on the bits of layers of interleaved coded digital stream;
- means for extracting, from each stream of weighted outputs on the layer bits, said a priori information on the layer bits, making it possible to produce a set of streams of extrinsic information on the layer bits;
- multiplexer means receiving said set of streams of extrinsic information on the layer bits and making it possible, by multiplexing, to produce said first stream of extrinsic information on the bits coded by the external code and interleaved,

the device being furthermore **characterized in that** said weighted input and output equalization and multilayer joint detection means are implemented according to a GPSP process consisting in preserving Ω surviving paths per node of the global reduced trellis, the calculation of said weighted outputs consisting of a process of generalized SOVA/SOVE type.

5. Device according to Claim 4, **characterized in that** said decoder means comprise:

- means for decoding with weighted input/output by means of said external code receiving said second stream of extrinsic information on the coded bits originating from the equalization process and making it possible to produce a stream of weighted outputs that are representative of a posteriori information on the coded bits;
- means for subtracting said second stream of extrinsic information from said stream of weighted outputs that are representative of said a posteriori information on the coded bits, making it possible to produce said third stream of extrinsic information on the coded bits.

6. Device according to one of Claims 4 and 5, **characterized in that**, for a set of transmitted elementary digital streams consisting of bursts comprising at least one string of binary learning symbols, it furthermore comprises means for calculating, for each iteration, on the basis of said learning symbols, an estimation of the coefficients of contribution to the intersymbol interference between constituent elementary channels of the transmission channel, the re-estimated values of these coefficients being reinjected into the equalization and detection process.

**Patentansprüche**

1. Verfahren zur Decodierung eines Stroms von codierten digitalen Daten mit Bitverschachtelung auf der Sendeseite und mit Mehrfachempfang auf einem Intersymbolinterferenzen erzeugenden Übertragungskanal, wobei dieser Strom von mit Verschachtelung codierten digitalen Daten aus einer Einheit von übertragenen elementaren digitalen Strömen besteht, die ausgehend von einem Ausgangsstrom digitaler Daten erhalten werden, der unterzogen wird:

- einer externen Codierung (A) mittels eines bestimmten Leistungscodes, um einen codierten digitalen Strom zu erzeugen,
- einer Verschachtelung (B) auf der Bitebene dieses codierten digitalen Stroms, um einen verschachtelten codierten digitalen Strom zu erzeugen,
- eine Schicht-Demultiplexierung (C) dieses verschachtelten codierten digitalen Stroms auf eine bestimmte Anzahl ν von demultiplexierten Pfaden, um eine entsprechende Anzahl von Schichten eines verschachtelten codierten digitalen Stroms zu erzeugen,

- eine Umwandlung (D) jeder digitalen Modulationsfolge, die aus $q_m$ aufeinanderfolgenden Bits der gleichen Schicht besteht, in ein Symbol $Q_m$-aire, $Q_m = 2^{q_m}$, gemäß einem spezifischen Abbildungsschema,

- eine Übertragung (E) jedes Symbols $Q_m$-aire mittels einer getrennten Sendeantenne, wobei die Einheit dieser Antennen ein Netz mit Raum-Diversity formt, das es ermöglicht, diese Einheit von übertragenen elementaren digitalen Strömen zu erzeugen,

**dadurch gekennzeichnet, dass** das Verfahren darin besteht:

- auf einer Vielzahl ρ von Empfangsantennen den Strom von codierten digitalen Daten mit Bitverschachtelung auf der Sendeseite und mit Mehrfachempfang zu empfangen (F), der aus der Einheit von elementaren digitalen Strömen besteht, die auf diesem Übertragungskanal übertragen werden, wobei die Empfangsantennen in einer Anzahl ρ unabhängig von der Anzahl ν von Sendeantennen vorliegen und ein Netz von Empfangsantennen mit Raum-Diversity formen, um eine Einheit von elementaren Strömen von empfangenen Modulationssymbolen zu definieren;

- die Einheit von elementaren Strömen von empfangenen Modulationssymbolen einem iterativen Prozess (G) der Entzerrung des Übertragungskanals und der gemeinsamen Mehrschicht-Erfassung mittels eines extrinsischen Informationsstroms über die durch den externen Code codierten und verschachtelten Bits zu unterziehen, wobei der extrinsische Informationsstrom eine a-priori-Information bildet, um einen ersten extrinsischen Informationsstrom über die durch den externen Code codierten und verschachtelten Bits zu erzeugen;

- den ersten extrinsischen Informationsstrom einer Entschachtelung (H) zu unterziehen, um einen zweiten extrinsischen Informationsstrom über die vom Entzerrungsprozess kommenden codierten Bits zu erzeugen;

- den zweiten extrinsischen Informationsstrom über die codierten Bits ausgehend von dem externen Code einer Decodierung (I) zu unterziehen, um einen dritten extrinsischen Informationsstrom über die codierten Bits zu erzeugen, der von der Decodierung ausgehend von dem externen Code stammt;

- den dritten extrinsischen Informationsstrom einer Verschachtelung (J) zu unterziehen, um den extrinsischen Informationsstrom über die durch den externen Code codierten und verschachtelten Bits zu erzeugen, der die a-priori-Information bildet;

- die a-priori-Information wieder in den iterativen Prozess der Entzerrung des Übertragungskanal und der gemeinsamen Mehrschicht-Erfassung einzuspeisen (K);

wobei der iterative Prozess der Entzerrung und der gemeinsamen Erfassung des Übertragungskanals darin besteht:

- den extrinsischen Informationsstrom über die vom externen Code codierten und verschachtelten Bits, der die a-priori-Information bildet, einer Schicht-Demultiplexierung in eine Einheit ν von a-priori-Informationsströmen über die Bits der Schichten eines verschachtelten codierten digitalen Stroms zu unterziehen;

- an den elementaren Strömen von empfangenen Modulationssymbolen ausgehend von den a-priori-Informationsströmen über die Bits der Schichten eine Entzerrung und eine gemeinsame Mehrschicht-Erfassung mit gewichtetem Eingang/Ausgang durchzuführen, die an ein globales Gitter mit reduzierter Anzahl von Zuständen angewendet wird, wobei dieses Gitter als das Gitter der elementaren Speicherkanäle definiert wird, die den Übertragungskanal bilden, wobei das globale Gitter aus einem kartesischen Produkt von den Kanälen zugeordneten Gittern mit reduzierter Anzahl von Zuständen resultiert, wobei die Anzahl der Zustände der Gitter reduziert wird, indem die Längenbedingung auf einen niedrigeren willkürlichen Wert reduziert wird, um eine Einheit von auf die Bits von Schichten eines verschachtelten codierten digitalen Strom gewichteten Ausgangsströmen zu erzeugen;

- aus jedem Strom von auf die Schicht-Bits gewichteten Ausgängen die a-priori-Information über die Schicht-Bits zu entnehmen, um eine extrinsische Informationsstromeinheit über die Schicht-Bits zu erzeugen;

- die extrinsische Informationsstromeinheit über die Schicht-Bits einer Multiplexierung zu unterziehen, um den ersten extrinsischen Informationsstrom über die vom externen Code codierten und verschachtelten Bits zu erzeugen,

wobei das Verfahren außerdem **dadurch gekennzeichnet ist, dass** der Schritt der Entzerrung und der gemeinsamen Mehrschicht-Erfassung mit gewichtetem Eingang und Ausgang von dem GPSP-Prozess durchgeführt wird, der darin besteht, Ω Überlebende pro Knoten des globalen reduzierten Gitters beizubehalten, wobei die Berechnung der gewichteten Ausgänge aus einem generalisierten SOVA-Prozess besteht.

2. Verfahren nach Anspruch 1, **dadurch gekennzeichnet, dass** die Decodierung (I) mittels des externen Codes darin besteht:

- den zweiten extrinsischen Informationsstrom über die vom Entzerrungsprozess kommenden codierten Bits einer Decodierung mit gewichtetem Eingang/Ausgang mittels des externen Codes zu unterziehen, um einen Strom von gewichteten Ausgängen zu erzeugen, die für eine a-posteriori-Information über die codierten Bits repräsentativ sind;
- den zweiten extrinsischen Informationsstrom von dem Strom von gewichteten Ausgängen, die für die a-posteriori-Information über die codierten Bits repräsentativ sind, zu subtrahieren, um den dritten extrinsischen Informationsstrom über die codierten Bits zu erhalten.

3. Verfahren nach einem der Ansprüche 1 und 2, **dadurch gekennzeichnet, dass** für eine Einheit von übertragenen elementaren digitalen Strömen, die aus Bursts bestehen, die mindestens eine Folge von binären Lernsymbolen aufweisen, dieses außerdem darin besteht:

- für jede Iteration ausgehend von Lernsymbolen eine Schätzung der Koeffizienten des Beitrags zur Intersymbolinterferenz zwischen elementaren Kanälen zu berechnen, die den Übertragungskanal bilden;
- in den Prozess der Entzerrung und der gemeinsamen Mehrschicht-Erfassung die neu geschätzten Werte dieser Koeffizienten wieder einzuspeisen.

4. Vorrichtung zur Decodierung eines Stroms von codierten digitalen Daten mit Bitverschachtelung auf der Sendeseite und mit Mehrfachempfang auf einem Interferenzintersymbole erzeugenden Übertragungskanal, wobei dieser Strom von codierten digitalen Daten mit Verschachtelung aus einer Einheit von digitalen Daten besteht, die unterzogen werden:

- einer externen Codierung (A, B) mittels eines bestimmten Leistungscodes, um einen verschachtelten codierten digitalen Strom zu erzeugen,
- einer Schicht-Demultiplexierung (C) dieses verschachtelten codierten digitalen Stroms auf eine bestimmte Anzahl $\nu$ von demultiplexierten Pfaden, um eine entsprechende Anzahl von Schichten eines verschachtelten codierten digitalen Stroms zu erzeugen,
- einer Umwandlung (D) jeder digitalen Modulationsfolge, die aus $q_m$ aufeinanderfolgenden Bits einer gleichen Schicht besteht, in ein Symbol $Q_m$-aire, $Qm = 2^{qm}$, gemäß einem spezifischen Abbildungsschema,
- einer Übertragung (E) jedes Symbols $Q_m$-aire mittels einer getrennten Sendeantenne, wobei die Einheit dieser Antennen ein Netz mit Raum-Diversity formt, das es ermöglicht, diese übertragene Einheit von elementaren digitalen Strömen zu erzeugen,

**dadurch gekennzeichnet, dass** die Decodiervorrichtung aufweist:

- eine Vielzahl $\rho$ von Empfangsantennen, die es ermöglichen, den Strom von codierten digitalen Daten mit Bitverschachtelung auf der Sendeseite und mit Mehrfachempfang zu empfangen (F), der aus der Einheit von auf diesem Übertragungskanal übertragenen elementaren digitalen Strömen besteht, wobei die Empfangsantennen in einer Anzahl $\rho$ unabhängig von der Anzahl $\nu$ von Sendeantennen vorliegen und ein Netz von Empfangsantennen mit Raum-Diversity formen, das es ermöglicht, eine Einheit von elementaren Strömen von empfangenen Modulationssymbolen zu formen;
- Einrichtungen zur Turboerfassung, die es ermöglichen, die Einheit von empfangenen elementaren Modulationsströmen einem iterativen Prozess (G) der Entzerrung des Übertragungskanals und der gemeinsamen Mehrschicht-Erfassung mittels eines extrinsischen Informationsstroms über die vom externen Code codierten und verschachtelten Bits zu unterziehen, wobei der extrinsische Informationsstrom eine a-priori-Information bildet, um einen ersten extrinsischen Informationsstrom über die vom externen Code codierten und verschachtelten Bits zu erzeugen;
- Entschachtelungseinrichtungen, die den ersten extrinsischen Informationsstrom empfangen und es durch dessen Entschachtelung (H) ermöglichen, einen zweiten extrinsischen Informationsstrom über die vom Entzerrungsprozess kommenden codierten Bits zu erzeugen;
- Decodiereinrichtungen, die den zweiten extrinsischen Informationsstrom über die codierten Bits empfangen und es durch dessen Decodierung (I) ausgehend von dem externen Code ermöglichen, einen dritten extrinsischen Informationsstrom über die codierten Bits zu erzeugen, der von der Decodierung ausgehend von dem externen Code stammt;
- Verschachtelungseinrichtungen, die den dritten extrinsischen Informationsstrom empfangen und es durch Verschachtelung (J) ermöglichen, den extrinsischen Informationsstrom über die durch den externen Code codierten und verschachtelten Bits zu erzeugen, der die a-priori-Information bildet;
- Einrichtungen zur erneuten Einspeisung der a-priori-Information in den iterativen Prozess der Entzerrung des Übertragungskanals und der gemeinsamen Mehrschicht-Erfassung;

wobei die Turboerfassungseinrichtungen aufweisen:

- Schicht-Demultiplexiereinrichtungen, die den extrinsischen Informationsstrom über die vom externen Code codierten und verschachtelten Bits empfangen, der die a-priori-Information bildet, was es durch Demultiplexierung auf eine Anzahl ν von Pfaden ermöglicht, eine Einheit ν von a-priori-Informationsströmen über die Bits der Schichten eines verschachtelten codierten digitalen Stroms zu erzeugen;
- Einrichtungen zur Entzerrung und zur gemeinsamen Mehrschicht-Erfassung, die einerseits die elementaren Ströme von empfangenen Modulationssymbolen und andererseits die a-priori-Informationströme über die Bits der Schichten empfangen, wobei die Einrichtungen zur Entzerrung und gemeinsamen Erfassung es ermöglichen, eine Entzerrung und eine gemeinsame Mehrschicht-Erfassung mit gewichtetem Eingang/Ausgang durchzuführen, die an ein globales Gitter mit reduzierter Anzahl von Zuständen angewendet wird, wobei dieses Gitter als das Gitter der elementaren Speicherkanäle definiert wird, die den Übertragungskanal bilden, wobei das globale Gitter aus einem kartesischen Produkt von Gittern mit reduzierter Anzahl von Zuständen resultiert, die den Kanälen zugeordnet sind, wobei die Anzahl der Zustände der Gitter reduziert wird, indem die Längenbedingung auf einen niedrigeren willkürlichen Wert reduziert wird, um eine Einheit von auf die Bits von Schichten eines verschachtelten codierten digitalen Stroms gewichteten Ausgangsströmen zu erzeugen;
- Einrichtungen zur Entnahme aus jedem Strom von auf die Bits eines verschachtelten codierten digitalen Stroms gewichteten Ausgängen;
- Einrichtungen zur Entnahme aus jedem Strom von auf die Schicht-Bits gewichteten Ausgängen der a-priori-Information über die Schicht-Bits, was es ermöglicht, eine extrinsische Informationsstromeinheit über die Schicht-Bits zu erzeugen;
- Multiplexeinrichtungen, die die extrinsische Informationsstromeinheit über die Schicht-Bits empfangen und es durch Multiplexierung ermöglichen, den ersten extrinsischen Informationsstrom über die vom externen Code codierten und verschachtelten Bits zu erzeugen;

wobei die Vorrichtung außerdem **dadurch gekennzeichnet ist, dass** die Einrichtungen zur Entzerrung und zur gemeinsamen Mehrschicht-Erfassung mit gewichtetem Eingang und Ausgang gemäß einem GPSP-Prozess angewendet werden, der darin besteht, Ω überlebende Wege pro Knoten des globalen reduzierten Gitters beizubehalten, wobei die Berechnung der gewichteten Ausgänge aus einem generalisierten SOVA/SOVE-Prozess besteht.

5.  Vorrichtung nach Anspruch 4, **dadurch gekennzeichnet, dass** die Decodiereinrichtungen aufweisen:

- Decodiereinrichtungen mit mittels des externen Codes gewichtetem Eingang/Ausgang, die den zweiten extrinsischen Informationsstrom über die vom Entzerrungsprozess kommenden codierten Bits empfangen und es ermöglichen, einen Strom von gewichteten Ausgängen zu erzeugen, die für eine a-posteriori-Information über die codierten Bits repräsentativ sind;
- Einrichtungen zur Subtraktion des zweiten extrinsischen Informationsstroms von dem Strom von gewichteten Ausgängen, die für die a-posteriori-Information über die codierten Bits repräsentativ sind, was es ermöglicht, den dritten extrinsischen Informationsstrom über die codierten Bits zu erzeugen.

6.  Vorrichtung nach einem der Ansprüche 4 und 5, **dadurch gekennzeichnet, dass** für eine Einheit von übertragenen elementaren digitalen Strömen, die aus Bursts besteht, die mindestens eine Folge von binären Lernsymbolen aufweisen, diese außerdem Berechnungseinrichtungen, für jede Iteration ausgehend von den Lernsymbolen, einer Schätzung der Beitragskoeffizienten zur Intersymbolinterferenz zwischen den Übertragungskanal bildenden elementaren Kanälen enthält, wobei die neu geschätzten Werte dieser Koeffizienten wieder in den Prozess der Entzerrung und der Erfassung eingespeist werden.

**FIG. 1a :** (Art antérieur)
Canal de Rayleigh

**FIG. 1b :** (Art antérieur)
Canal de Rayleigh

**FIG. 4a**

IDS

$\{d_1, ..., d_{\tau 0}\}$

CODAGE EXTERNE
C° — A

$\underline{d}_n = \{d_{n, 1}, ..., d_{n,k_0}\}$

C°DS

$\{\underline{c}_1, ..., \underline{c}_{\tau 0}\}$

ENTRELACEMENT PAR BLOCS
$\pi$ — B

$\underline{c}_n = \{c_{n, 1}, ..., c_{n,n_0}\}$

ILC°DS

DEMUX
$\nu$ voies — C

$\{EILC°DS_m\}_{m=1}^{m=\nu}$

MODULATION — D

TRANSMISSION SUR ANTENNE
DISTINCTE $\quad \{ta_m\}_{m=1}^{m=\nu}$

E

$\{TEILCDS_m\}_{m=1}^{m=\nu}$

**FIG. 2**

$$\{TEILCDS_m\}_{m=1}^{m=\nu}$$

$$\{ra_r\}_{r=1}^{r=\rho} \quad \diagdown F$$

$$\{MSDS_r\}_{r=1}^{r=\rho} \Rightarrow MSDS_r$$

EIDS=api

ÉGALISATION ET DÉTECTION
CONJOINTE
MULTICOUCHE $\quad \diagdown G$

$\hat{H}$

K

$EIDS_1$

DÉSENTRELACEMENT
$\pi^{-1}$ $\quad \diagdown H$

$EIDS_2$

DÉCODAGE
$C°$ $\quad \diagdown I$

$EIDS_3$

$\widehat{IDS}$

ENTRELACEMENT
$\pi$ $\quad \diagdown J$

EIDS

**FIG. 3a**

$\{MSDS_r\}\,_{r=1}^{r=\rho}$

$\{APIUDS_m\}\,_{m=1}^{m=\nu}$

$\hat{H} = \{h^{t,m,r}\}\,_{t=1,m=1,r=1}^{\eta_m \quad \nu \quad \rho}$

$G_1$

$G_2$

EIDS=api

DEMUX

$\nu$ voies

ÉGALISATION ET DÉTECTION CONJOINTE MULTICOUCHE SISO

$\{EUDSSO_m\}\,_{m=1}^{m=\nu}$

SOUSTRACTION

$\{EUDSSO_m - APIUD_m\}\,_{m=1}^{m=\nu}$

$G_3$

$G$

$\{EIEUSO_m\}\,_{m=1}^{m=\nu}$

MUX

$G_4$

$EIDS_1$

**FIG. 3b**

$EIDS_2$

$I$

DÉCODAGE SISO C°

$I_1$

APOSO

$\hat{IDS}$

$EIDS_2$

SOUSTRACTION APOSO-$EIDS_2$

$I_2$

$EIDS_3$

**FIG. 3c**

FIG. 4b

**FIG. 5a :** processus selon figure 1a (Art antérieur)

**FIG. 5b :** processus selon l'invention : V=3
codage selon figure 2
décodage selon figure 3a

**FIG. 5c :** processus selon l'invention : V=4
codage selon figure 2
décodage selon figure 3a

**FIG. 5d :** processus selon l'invention en fonction
du nombre de survivants $\Omega$
codage selon figure 2
décodage selon figure 3a

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Littérature non-brevet citée dans la description**

- **EPHRAIM ZEHAVI.** 8-PSK Trellis Codes for a Rayleigh Channel. *IEEE Transactions on Communications,* 1992, vol. 40 (5
- **G.CAIRE ; G. TARICCO ; E. BIGLIERI.** Bit Interleaved Coded Modulation. *IEEE Trans. Inform. Theory,* Mai 1998, vol. 44 (3), 927-946
- **X.LI ; J.A. RITCEY.** Trellis-Coded Modulation with Bit-Interleaving and Iterative Decoding. *IEEE ISAC,* Avril 1992, vol. 17 (4), 715-725
- **JJ. BOUTROS ; F. BOIXADERA ; C. LAMY.** Bit-Interleaved Coded Modulations for Multiple-Input Multiple Output Channels. *IEEE 6th Int. Sum. on Spread Spectrum Tech & Appli. NSIT,* 06 Septembre 2000
- **ANDREJ STEFANOV ; TOLGA M. DUMAN.** Turbo Coded Modulation for Systems with Transmit and Receive Antenna Diversity. *Global Telecommunications Conference - Globecom 99,* 1999
- **A.M.TONELLO.** Space-Time Bit-Interleaved Coded Modulation over Frenquency Selective Fading Channels with Iterative Decoding. *GLOBECOM 2000,* Novembre 2000, vol. 3, 1616-1620
- Turbo Space-Time Processing to Improve Wireless Channel Capacity. *Sirikiat Lek Aryavisitakul,* 1347-1359
- **R.VISOZ ; A.O.BERTHET ; P.TORTELIER.** Joint Equalization and Decoding of Trellis-Encoded Signals using the Generalized Viterbi Algorithm. *IEEE VTC,* 2000
- **G.BAUCH ; V.FRANZ.** A Comparison of Soft-in and Soft-out Algorithms for Turbo-Detection. *Proceedings of ICT,* Juin 1998, vol. 2, 259-263
- **J.HAGENAUER ; P.HOEHER.** A Viterbi Algorithm with Soft-Decision Outputs and its Applications. *Proc., IEEE Globecom'89,* Novembre 1989, 1680-1686